# EUROPÄISCHE PATENTSCHRIFT

(11) **EP 1 363 923 B1**
(45) Veröffentlichungstag und Bekanntmachung des Hinweises auf die Patenterteilung: **01.04.2009**
(21) Anmeldenummer: 02702360.5
(22) Anmeldetag: 21.02.2002
(51) Int. Cl.: C07F 15/00, H01L 51/30

(54) **RHODIUM- UND IRIDIUM-KOMPLEXE**
RHODIUM AND IRIDIUM COMPLEXES
COMPLEXES DE RHODIUM ET D'IRIDIUM

(30) Priorität: 24.02.2001 DE 10109027
(43) Veröffentlichungstag der Anmeldung: 26.11.2003
(73) Patentinhaber: Merck Patent GmbH, 64293 Darmstadt (DE)
(72) Erfinder: STÖSSEL, Philipp, 65929 Frankfurt (DE); SPREITZER, Hubert, 68519 Viernheim (DE); BECKER, Heinrich, 61479 Glashütten (DE)
(86) Internationale Anmeldenummer: PCT/EP2002/001841
(87) Internationale Veröffentlichungsnummer: WO 2002/068435

(56) Entgegenhaltungen:
- EP-A- 1 191 613
- US-A- 4 539 507
- US-A- 5 151 629

## Beschreibung

Metallorganische Verbindungen - speziell Verbindungen der d⁸-Metalle - werden in naher Zukunft als Wirkkomponenten (= Funktionsmaterialien) in einer Reihe von verschiedenartigen Anwendungen, die im weitesten Sinne der Elektronikindustrie zugerechnet werden können, Einsatz als funktionelle Komponenten finden.
Bei den auf organischen Komponenten basierenden Organischen-Elektrolumineszenz-Vorrichtungen (allg. Beschreibung des Aufbaus vgl.
US-A-4,539,507 und US-A-5,151,629) bzw. deren Einzelbauteilen, den Organischen-Lichtemittierenden-Dioden (OLEDs) ist die Markteinführung bereits erfolgt, wie die erhältlichen Auto-Radios mit "Organischem Display" der Firma Pioneer belegen. Weitere derartige Produkte stehen kurz vor der Einführung. Trotz allem sind hier noch deutliche Verbesserungen nötig, um diese Displays zu einer echten Konkurrenz zu den derzeit marktbeherrschenden Flüssigkristallanzeigen (LCD) zu machen bzw. diese zu überflügeln.
Eine Entwicklung hierzu, die sich in den letzten beiden Jahren abzeichnet, ist der Einsatz von metallorganischen Komplexen, die Phosphoreszenz statt Fluoreszenz zeigen [M. A. Baldo, S. Lamansky, P. E. Burrows, M. E. Thompson, S. R. Forrest, Applied Physics Letters, 1999, 75, 4-6].
Aus theoretischen Spin-statistischen Gründen ist unter Verwendung metallorganischer Verbindungen als Phosphoreszenz-Emittern eine bis zu vierfache Energie- und Leistungseffizienz möglich. Ob sich diese neue Entwicklung durchsetzten wird, hängt stark davon ab, ob entsprechende Device-Kompositionen gefunden werden können, die diese Vorteile (Triplett-Emission = Phosphoreszenz gegenüber Singulett-Emission = Fluoreszenz) auch in den OLEDs umsetzen können. Als wesentliche Bedingungen für praktische Anwendung sind hier insbesondere eine hohe operative Lebensdauer, eine hohe Stabilität gegenüber Temperaturbelastung und eine niedrige Einsatz- und Betriebsspannung, um mobile Applikationen zu ermöglichen, zu nennen.

Daneben muß der effiziente chemische Zugang zu den entsprechenden Organo-Metall-Verbindungen gegeben sein. Von besonderem Interesse sind dabei Organo-Rhodium- und Iridium-Verbindungen. Bei diesen ist vor allem unter Berücksichtigung des Rhodium- bzw. des Iridiumpreises von maßgebender Bedeutung, daß hier ein effizienter Zugang zu entsprechenden Derivaten ermöglicht wird.

5'-Mono-, 5',5"-Di- und 5',5",5"'-Tri-Halogen-funktionalisierte tris-orthometallierte Organo-Rhodium- und Organo-Iridium-Verbindungen (gemäß Verbindungen (I) oder (II)), 5',5"-Di- und 5',5",5"',5""-Tetra-Halogen-funktionalisierte tetrakisorthometallierte verbrückte Organo-Rhodium- und Organo-Iridium-Verbindungen (gemäß Verbindung (V) und (VII)) und kationische, neutrale oder anionische 5'-Mono- und 5',5"-Di-Halogen-funktionalisierte bis-orthometallierte Organo-Rhodium-und Organo-Iridium-Verbindungen (gemäß Verbindung (IX), (XI), (XIII) und (XV)), die Gegenstand der vorliegenden Erfindung sind, werden zentrale Schlüsselbausteine zur Erzeugung hocheffizienter Triplett-Emitter sein, da die Halogenfunktion mit Hilfe von gängigen, in der Literatur beschriebenen Methoden in eine Vielzahl von Funktionen umgewandelt werden kann. Damit ist nicht nur der kovalente Einbau dieser aktiven, lichtemittierenden Zentren in eine Vielzahl von Polymeren möglich, sondern auch das Maßschneidern der optoelektronischen Eigenschaften dieser Bausteine. So sind hier - ausgehend von den genannten Strukturen - typische C-C-Verknüpfungsreaktionen (z. B. Stille- oder Suzukikopplung), oder auch C-Heteroatom-Verknüpfungsreaktionen (z. B. für C-N: Hartwig-Buchwald-Kopplung, ähnliches auch für C-O und C-P) möglich, um damit die halogenfunktionalisierten Verbindungen entweder weiter zu funktionalisieren, oder als (Co)monornere bei der Darstellung von entsprechenden Polymeren zu verwenden.

5'-Mono--, 5',5"-Di- und 5',5",5"'-Tri-Halogen-funktionalisierte tris-orthometallierte Organo-Rhodium- und Organo-Iridium-Verbindungen (gemäß Verbindungen (I) oder (II)) , 5',5"-Di- und 5',5",5"',5""-Tetra-Halogen-funktionalisierte tetrakisorthometallierte verbrückte Organo-Rhodium- und Organo-Iridium-Verbindungen (gemäß Verbindung (V) und (VII)) und kationische, neutrale oder anionische 5'-Mono- und 5',5"-Di-Halogen-funktionalisierte bis-orthometallierte Organo-Rhodium-und Organo-Iridium-Verbindungen (gemäß Verbindung (IX), (XI), (XIII) und (XV)) sind bisher in der Literatur nicht beschrieben worden, ihre effiziente Darstellung und Verfügbarkeit als Reinstoffe ist aber für verschiedene elektro-optische Anwendungen von großer Bedeutung.

Als nächstliegender Stand der Technik kann die Mono-Bromierung und Monolodierung eines kationischen Ruthenium(II)komplexes, der neben dem orthometallierten 2-Phenylpyridin-Liganden auch noch 2,2'-Bipyridinliganden trägt, gesehen werden [C. Coudret, S. Fraysse, J.-P- Launay, Chem. Commun., 1998, 663-664]. Als Bromierungsagenz wird N-Brom-succinimid, als lodierungsagenz ein Gemisch aus Iodbenzol-diacetat und elementarem Iod im molaren Verhältnis von eins zu eins verwendet. Die isolierte Ausbeute nach chromatographischer Reinigung wird im Fall der Bromierung mit 95 %, im Fall der Jodierung mit 50 % angegeben.
Analog ist auch die von Clark et al. beschriebene Bromierung orthomethallierter 2-Phenylchinolin- und 2,3-Diphenylchinoxalin-Liganden von Ruthenium(II)- und Osmium(II)-Carbony-Chloro-Komplexen mit Pyridiniumperbromid zu sehen. Nach chromatographischer Reinigung wurden Ausbeuten von 27 % bis 92 % erhalten [A. M. Clark, C. E. F. Rickard, W. R. Roper, L. J. Wright J. Organomet. Chem., 2000, 598, 262-275].
Diese beide Stellen weisen folgende Nachteile auf:
(1) Es wird nur die Derivatisierung von Ru- oder Os-Komplexen, nicht aber diejenige von Rh- oder Ir-Verbindungen beschrieben.
(2) Es wird keine sinnvolle Lehre erteilt, wie man - beim Vorliegen von mehreren substituierbaren Stellen - gezielt zu den gewünschten Mono-, oder Di-, oder Tri-oder Tetra- funktionalisierten Verbindungen gelangt, da in beiden Fällen jeweils nur eine Halogenierung pro Komplex-Molekül möglich ist.

Dagegen ist die selektive 5'-Mono-, 5',5"-Di-, 5',5",5"'-Tri- und 5',5",5"',5""-Tetra-Halogenierung von bis-, tris- oder tetrakis-orthometallierten Organo-Rhodium- bzw. Organo-Iridium-Verbindungen in der Literatur bisher nicht beschrieben worden.

Es wurde nun überraschend gefunden, daß die neuen Verbindungen (I) oder (II) - gemäß Schema 1 - ausgehend von tris-orthometallierten Organo-Rhodium bzw.

Organo-Iridium-Verbindungen, und daß die neuen Verbindungen (V) oder (VII) - gemäß Schema 2 - ausgehend von tetrakis-orthometallierten verbrückten Organo-Rhodium- und Organo-Iridium-Verbindungen, und daß die neuen Verbindungen (IX), (XI), (XIII) oder (XV) - gemäß Schema 3 - ausgehend von kationischen, neutralen oder anionischen funktionalisierten bis-orthometallierten Organo-Rhodium- und Organo-Iridium-Verbindungen mit einem Halogen bzw. Interhalogen, in Anwesenheit einer Base und gegebenenfalls einer Lewissäure, bzw. einer organischen N-Halogen-Verbindung bzw. einem Halogenierungsagenz bestehend aus einer organischen O-Halogen-Verbindung und einem Halogen X₂, unter geeigneter Wahl des stöchiometrischen Verhältnisses des entsprechenden Halogenierungsagenz zu den Verbindungen (III), (IV), (VI), (VIII), (X), (XII), (XIV) bzw. (XVI) sowie unter geeigneter Wahl der Reaktionsparameter wie Reaktionstemperatur, Reaktionsmedium, Konzentration und Reaktionszeiten reproduzierbar in etwa 90 - 98 % iger Ausbeute, ohne Verwendung chromatographischer Reinigungsverfahren, in Reinheiten von
> 99 % nach NMR bzw. HPLC erhalten werden (siehe Beispiel 1-10).

Das oben beschriebene Verfahren zeichnet sich durch drei Eigenschaften besonders aus, die in dieser Form bisher nicht in der Literatur beschrieben wurden:
Erstens ist die selektive 5'-Mono-, 5',5"-Di-, 5',5",5"'-Tri- und 5',5",5"',5""-Tetra-Halogenierung unerwartet und in dieser Form nicht bekannt. Vermutlich resultiert sie aus der Aktivierung, die die zum Rhodium- bzw. Iridium-Atom para-ständige Position durch dieses erfährt. Die unerwartet hohe Aktivität dieser Position gegenüber einer elektrophilen Substitution, hier der Halogenierung, wird durch den Einsatz milder Halogenierungsagentien gezielt ausgenutzt.
Entscheidend zur Erzielung von hohen Selektivitäten und hohen Reaktionsgeschwindigkeiten ist das Arbeiten in Gegenwart eines säurebindenden Agenz, welches die im Verlauf der Substitution gebildete Halogenwasserstoffsäure bindet. Dies ist ein überraschender Befund, durch den Nebenreaktionen offenbar wirksam unterdrückt werden.
Die erfindungsgemäßen Halogenierungsagentien enthalten dementsprechend ein säurebindendes Agenz, wie eine Base, welche entweder intrinsischer Bestandteil des Halogenierungsagenz ist oder zusätzlich zum Halogenierungsagenz zugesetzt wird.

Zweitens ist der hohe erzielte Umsatz, der sich in den reproduzierbar sehr guten Ausbeuten an isoliertem Produkt wiederspiegelt, unerwartet und einzigartig für die Halogenierung von orthometallierten Liganden, gebunden an Metalle der Eisentriade.

Drittens fallen die erhaltenen Verbindungen, ohne aufwendige chromatographische Reinigung, in sehr guten Reinheiten von > 99 % nach NMR bzw. HPLC an. Dies ist für die Verwendung in opto-elektronischen Bauelementen, bzw. der Benutzung als Zwischenprodukte für die Darstellung entsprechender Verbindungen essentiell.

Wie oben geschildert, sind die erfindungsgemäßen Verbindungen nicht vorbeschrieben und damit neu.

Gegenstand der vorliegenden Erfindung sind somit die Verbindungen (I) und (II) gemäß Schema 1, 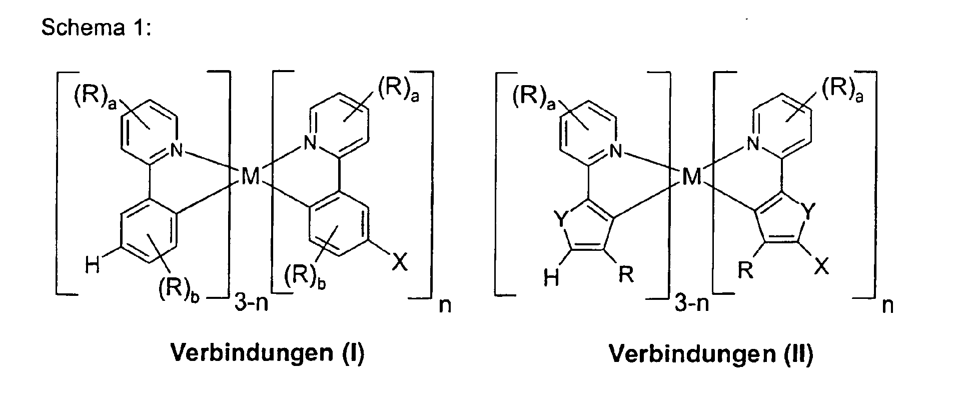 wobei die Symbole und Indizes folgende Bedeutung haben:
- M: Rh, Ir
- X: F, Cl, Br, I
- Y: O, S, Se
- R: ist gleich oder verschieden bei jedem Auftreten H, F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR²-ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
- R¹ und R²: sind gleich oder verschieden, H oder ein aliphatischer oder aromatischer Kohlenwasserstoffrest mit 1 bis 20 C-Atomen,
- a: ist 0, 1, 2, 3 oder 4, bevorzugt 0, 1 oder 2,
- b: ist 0, 1, 2 oder 3, bevorzugt 0 oder 1.
- n: ist 1, 2 oder 3

Eine weitere Ausführungsform der Erfindung sind solche Rh- bzw. Ir-komplexe, die gleichzeitig Liganden vom Typ wie bei Verbindungen (I) und solche von Verbindungen (II) aufweisen, d.h. gemischte Ligandensysteme. Diese werden durch die Formeln (Ia) und (IIa) beschrieben: 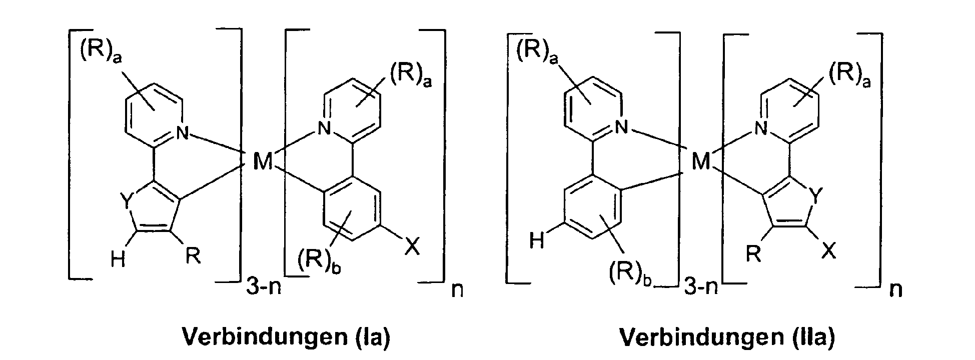 wobei die Symbole und Indizes die unter den Formel (I) und (II) genannten Bedeutungen haben.

Ebenfalls Gegenstand der vorliegenden Erfindung sind somit die Verbindungen (V) und (VII) gemäß Schema 2, 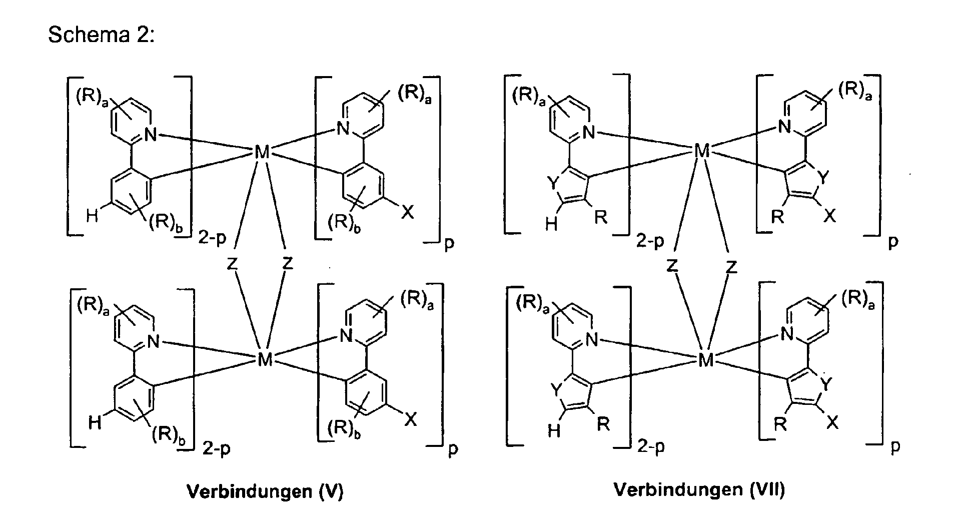 wobei die Symbole und Indizes folgende Bedeutung haben:
- M: Rh, Ir
- X: F, Cl, Br, I
- Y: O, S, Se
- Z: ist gleich F, Cl, Br, J, O-R¹, S-R¹, N(R¹)₂
- R: ist gleich oder verschieden bei jedem Auftreten H, F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder-CONR²-ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
- R¹ und R²: sind gleich oder verschieden, H oder ein aliphatischer oder aromatischer Kohlenwasserstoffrest mit 1 bis 20 C-Atomen,
- a: ist 0, 1, 2, 3 oder 4, bevorzugt 0, 1 oder 2,
- b: ist 0, 1, 2 oder 3, bevorzugt 0 oder 1.
- p: ist 1 oder 2

Ebenfalls Gegenstand der vorliegenden Erfindung sind somit die Verbindungen (IX), (XI), (XIII) und (XV) gemäß Schema 3 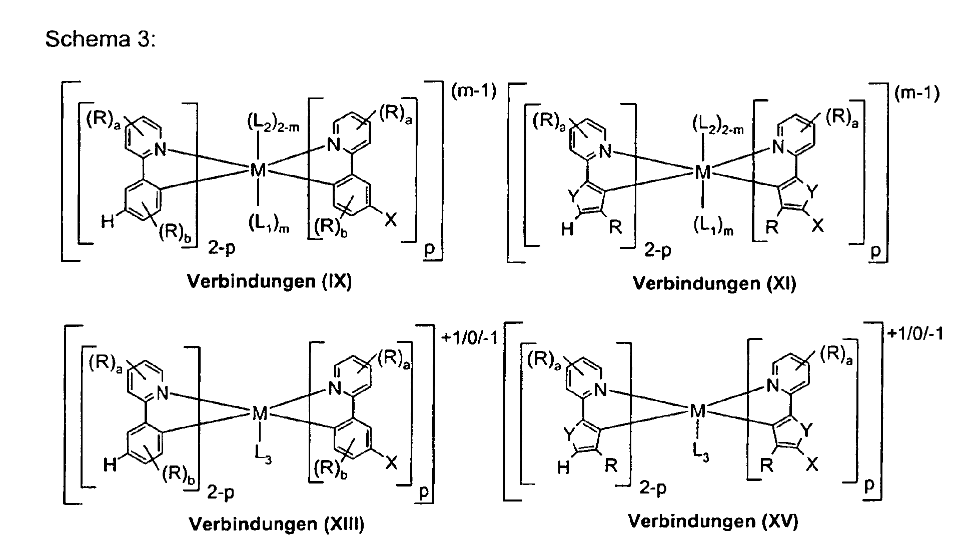 wobei die Symbole und Indizes folgende Bedeutung haben:
- M: Rh, Ir
- X: F, Cl, Br, I
- Y: O, S, Se
- R: ist gleich oder verschieden bei jedem Auftreten H, F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR²-ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
- R¹ und R²: sind gleich oder verschieden, H oder ein aliphatischer oder aromatischer Kohlenwasserstoffrest mit 1 bis 20 C-Atomen,
- L₁: ist ein neutraler, einzähniger Ligand
- L₂: ist ein monoanionischer, einzähniger Ligand
- L₃: ist ein neutaler oder mono- oder dianionischer zweizähniger Ligand
- a: ist 0, 1, 2, 3 oder 4, bevorzugt 0, 1 oder 2,
- b: ist 0, 1, 2 oder 3, bevorzugt 0 oder 1.
- m: ist 0, 1 oder 2
- p: ist 1 oder 2

Erfindungsgemäße neutrale, einzähnige Liganden L₁ sind Kohlenmonoxid, Isonitrile wie z.B. *tert*-Butyl-isonitril, Cyclohexylisonitril, Adamantylisonitril, Amine wie z.B. Trimethylamin, Triethylamin, Morpholin, Phosphine wie z.B. Trifluorphosphin, Trimethylphosphin, Tricyclohexylphosphin, Tri-*tert*-butylphosphin, Triphenylphosphin, Tris(pentafluorphenyl)phosphin, Phosphite wie z.B. Trimethylphosphit, Triethylphosphit, Arsine wie z.B. Trifluorarsin, Trimethylarsin, Tricyclohexylarsin, Tri-*tert*-butylarsin, Triphenylarsinin, Tris(pentafluorphenyl)arsin, Stibine wie z.B. Trifluorstibin, Trimethylstibin, Tricyclohexylstibin, Tri-*tert*-butylstibin, Triphenylstibin, Tris(pentafluorphenyl)stibin und stickstoffhaltige Heterocyclen wie z.B. Pyridin, Pyridazin, Pyrazin, Triazin.

Erfindungsgemäße monoanionische, einzähnige Liganden L₂ sind Halogenide, Cyanid, Cyanat, Iso-cyanat, Thiocyanat, Iso-thiocyanat, Alkoholate wie z.B. Methanolat, Ethanolat, Propanolat, *iso*-Propanolat, *tert*-Butylat, Phenolat, Thioalkoholate wie z.B. Methanthiolat, Ethanthiolat, Propanthiolat, *iso*-Propanthiolat, *tert*-Thiobutylat, Thiophenolat, Amide wie z.B. Dimethylamid, Diethylamid, Di-*iso-*propylamid, Pyrrolid, Morpholid, Carboxyalate wie z.B. Acetat, Trifluoracetat, Propionat, Benzoat und anionische, stickstoffhaltige Heterocyclen wie Pyrrolid, Imidazolid, Pyrazolid.

Erfindungsgemäße neutale oder mono- oder dianionische zweizähnige Liganden L₃ sind Diamine wie z. B. Ethylendiamin, N,N,N',N'-Tetramethylethylendiamin, Propylendiamin, N,N,N',N'-Tetramethylpropylendiamin, cis-, trans-Diaminocyclohexan, cis-, trans-N,N,N',N'-Tetramethyldiaminocyclohexan, Imine wie z.B. 2[(1-(Phenylimino)ethyl]pyridin, 2[(1-(2-Methylphenylimino)ethyl]pyridin, 2[(1-(2,6-Di-iso-propylphenylimino)ethyl]pyridin, 2[(1-(Methylimino)ethyl]pyridin, 2[(1-(ethylimino)ethyl]pyridin, 2[(1-(*Iso*-Propylimino)ethyl]pyridin, 2[(1-(*Tert-*Butylimino)ethyl]pyridin, Dimine wie z.B. 1,2-Bis(methylimino)ethan, 1,2-Bis(ethylimino)ethan, 1,2-Bis(*iso*-propylimino)ethan, 1,2-Bis(*tert-*butylimino)ethan, 2,3-Bis(methylimino)butan, 2,3-Bis(ethylimino)butan, 2,3-Bis(*iso-*propylimino)butan, 2,3-Bis(*tert*-butylimino)butan, 1,2-Bis(phenyimino)ethan, 1,2-Bis(2-methylphenyimino)ethan, 1,2-Bis(2,6-di-*iso*-propylphenyimino)ethan, 1,2-Bis(2,6-di-*tert*-butylphenyimino)ethan, 2,3-Bis(phenyimino)butan, 2,3-Bis(2-methylphenyimino)butan, 2,3-Bis(2,6-di-*iso*-propylphenyimino)butan, 2,3-Bis(2,6-di-*tert*-butylphenyimino)butan, Heterocylen enthaltend zwei Stickstoffatome wie z.B. 2,2'-Bipyridin, o-Phenanthrolin, Diphosphine wie z.B. Bis-diphenylphosphinomethan, Bis-diphenylposphinoethan, Bis(diphenylphosphino)propan, wie Bis(dimethylphosphino)methan, wie Bis(dimethylposphino)ethan, Bis(dimethylphosphino)propan, wie Bis(diethylposphino)methan, Bis(diethylposphino)ethan, Bis(diethylphosphino)propan, Bis(di-*tert-*butylphosphino)methan, wie Bis(di-*tert*-butylposphino)ethan, Bis(*tert-*butylphosphino)propan, 1,3-Diketonate abgeleitet von 1,3-Diketonen wie z.B. Acetylaceton, Benzoylaceton, 1,5-Diphenylacetylaceton, Dibenzolymethan, Bis(1,1,1-tri-fluoracetyl)methan, 3-Ketonate abgeleitet von 3-Ketoestern wie z.B. Acetessigsäureethylester, Carboxylate abgeleitet von Aminocarbonsäuren wie z.B. Pyridin-2-carbonsäure, Chinolin-2-carbonsäure, Glycin, Dimethylglycin, Alanin, Dimethylaminoalanin, Salicyliminate abgeleitet von Salicyliminen wie z.B. Methylsalicylimin, Ethylsalicylimin, Phenylsalicylimin, Dialkoholate abgeleitet von Dialkoholen wie z.B. Ethylenglykol, 1,3-Propylenglykol, Ditholate abgeleitet von Dithiolen wie z.B. 1,2-Ethylendithiol, 1,3-Propylendithiol.

Ein weiterer Gegenstand der vorliegenden Erfindung sind Verfahren zur Herstellung der Verbindungen (I) bzw. (II), durch Umsetzung der Verbindungen (III) bzw. (IV), 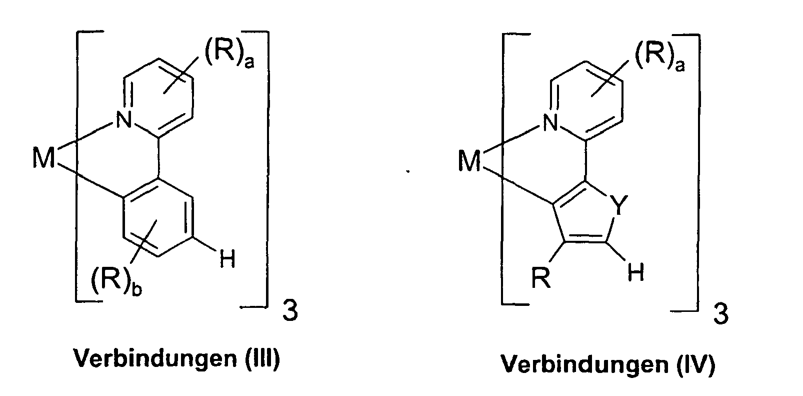 worin M und die Reste und Indizes Y, R, a, und b die oben genannten Bedeutungen haben, mit Halogenierungsagentien.

Ein weiterer Gegenstand der vorliegenden Erfindung sind Verfahren zur Herstellung der Verbindungen (V) bzw. (VII), durch Umsetzung der Verbindungen (VI) bzw. (VIII), 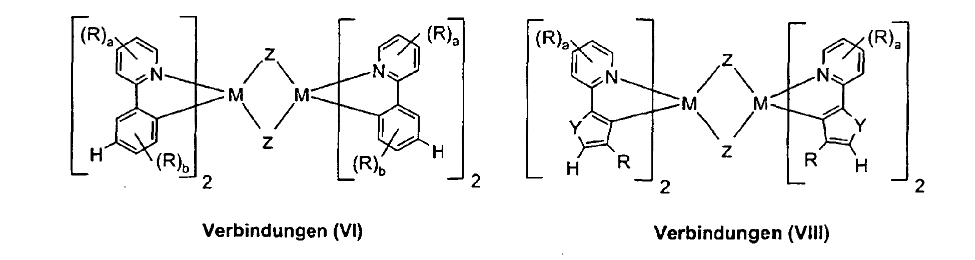 worin M und die Reste und Indizes Z, Y, R, a, und b die oben genannten Bedeutungen haben, mit Halogenierungsagentien.

Ein weiterer Gegenstand der vorliegenden Erfindung sind Verfahren zur Herstellung der Verbindungen (IX), (XI), (XIII) bzw. (XV) durch Umsetzung der Verbindungen (X), (XII), (XIV) bzw. (XVI) 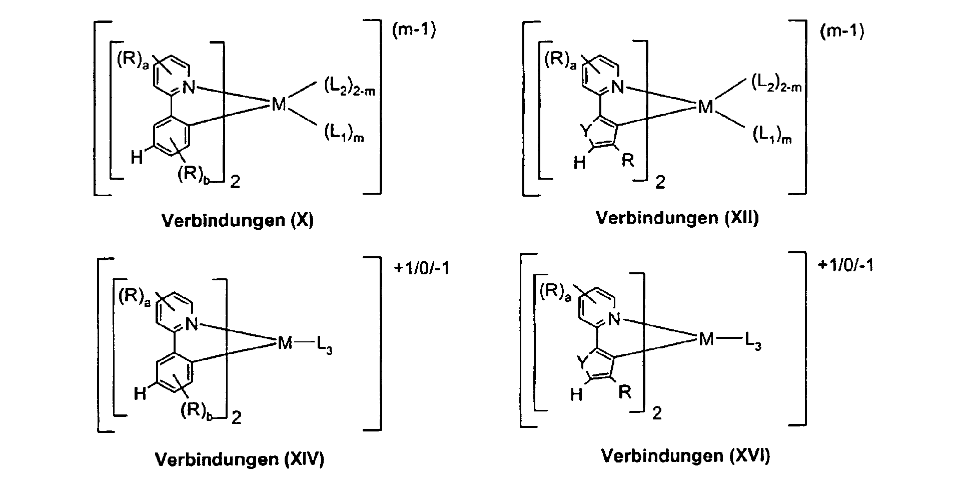 worin M und die Reste und Indizes L₁, L₂, L₃, Y, R, a, b und m die oben genannten Bedeutungen haben, mit Halogenierungsagentien.

Das erfindungsgemäße Verfahren wird durch Schema 4 erläutert:Schema 4:

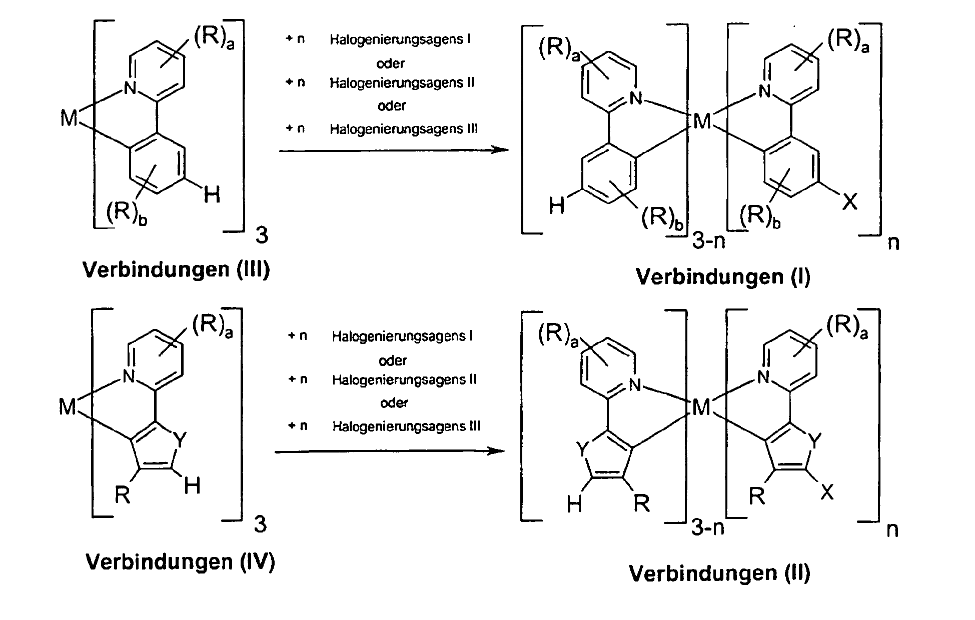

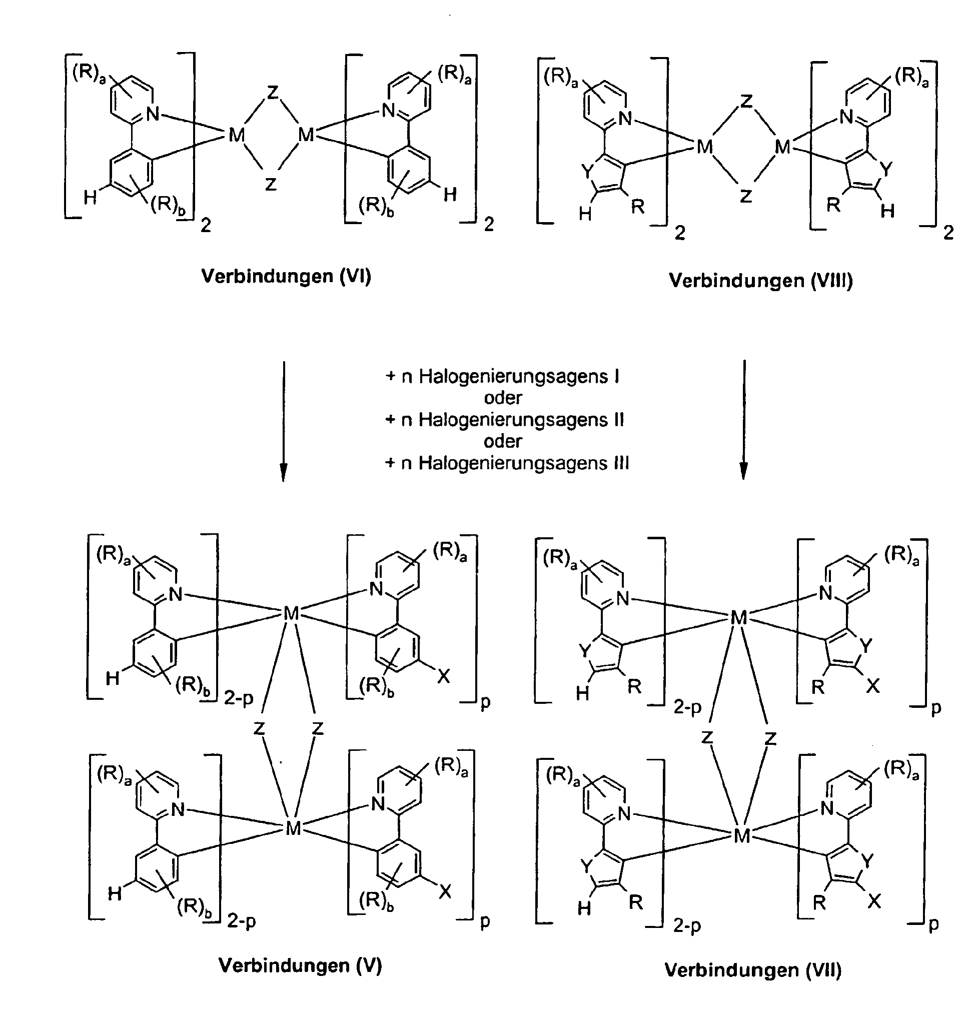

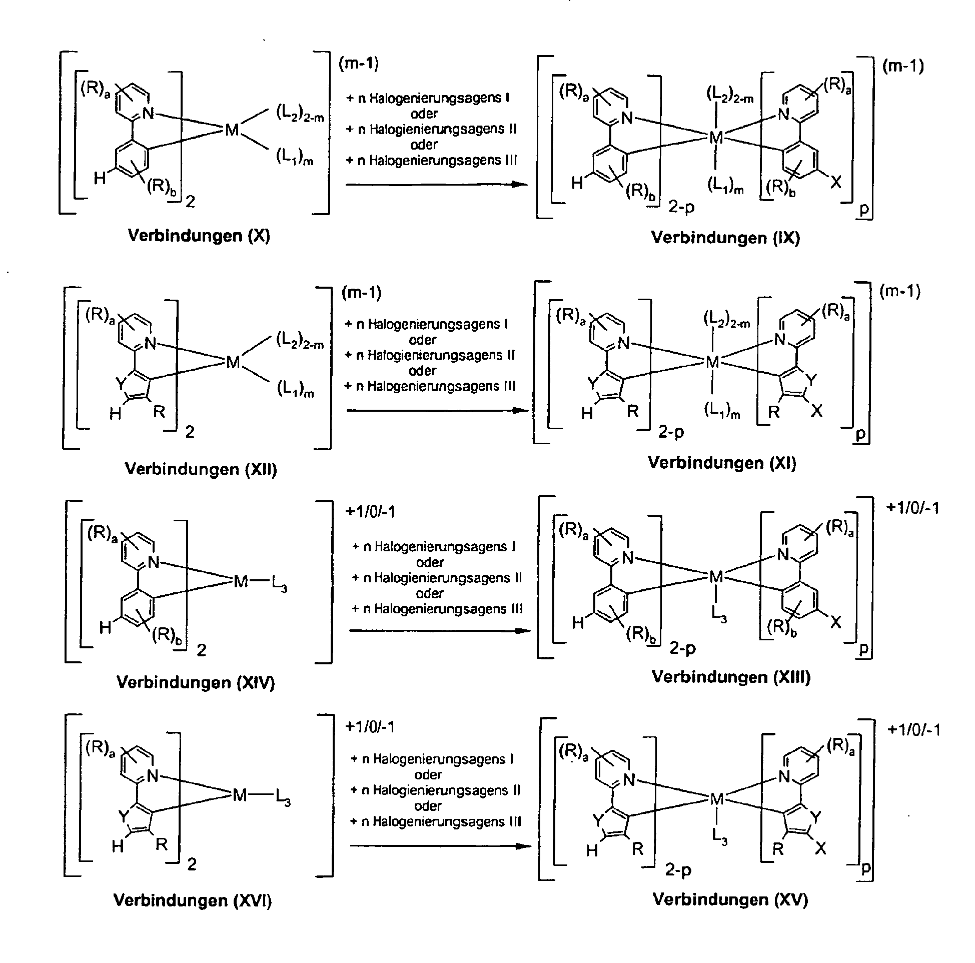

Erfindungsgemäße Halogenierungsagentien sind die Halogene X₂ bzw. die Interhalogene X-X und eine Base im Verhältnis 1 : 1 bis 1 : 100 und gegebenenfalls eine Lewis-Säure im Verhältnis (Halogen zu Lewissäure) von 1 : 0.1 bis 1 : 0.0001, so z.B. Chlor, Brom oder Iod bzw. Chlorfluorid, Bromfluorid, Iodfluorid, Bromchlorid, lodchlorid oder lodbromid in Kombination mit organischen Basen wie Aminen, so z.B. Triethylamin, Tri-n-butylamin, Diisopropyl-ethylamin, Morpholin, N-Methylmorpholin und Pyridin, oder Salzen von Carbonsäuren wir Natriumacetat, Natriumpropionat, Natriumbenzoat, oder anorganische Basen wie Natrium- oder Kalium-phosphat oder -hydrogenphosphat, Natrium- oder Kaliumhydrogencarbonat, Natrium- oder Kaliumcarbonat, aber auch organische Bromkomplexe, wie Pyridiniumperbromid, jeweils gegebenenfalls in Kombination mit einer Lewis-Säure wie z.B. Bortrifluorid, Bortrifluoridetherat, Bortrichlorid, Bortribromid, Bortrijodid, Aluminiumtrichlorid, Aluminiumtribromid, Aluminiumtriodid, Eisen(III)chlorid, Eisen(III)bromid, Zink(II)chlorid, Zink(II)bromid, Zinn(IV)chlorid, Zinn(IV)bromid, Phosphorpentachlorid, Arsenpentachlorid und Antimonpentachlorid.
Diese Halogenierungsagentien werden nachfolgend Halogenierungsagentien (I) genannt.

Weitere erfindungsgemäße Halogenierungsagentien sind organische N-X-Verbindung, wie 1-(Chlormethyl)-4-fluor-1,4-diazonia-bicyclo-[2.2.2]-octan-bis-(tetra-fluoroborat), N-Halogen-carbonsäureamide so z. B. N-Chlor-, N-Brom und N-lod-acetamid, N-Chlor-, N-Brom- und N-Iod-propionamid, N-Chlor-, N-Brom und N-lod-benzoesäureamid, oder N-Halogen-carbonsäureimide wie z.B. N-Chlor-, N-Brom- und N-Iod-succinimid, N-Chlor-, N-Brom und N-Iod-phthalimid, oder N-Dihalogen-sulfonsäureamide, wie Benzolsulfo-N-dibromamid, oder N-Halogensulfonsäureamid-salze, wie Chloramin B oder T.
Diese Halogenierungsagentien werden nachfolgend Halogenierungsagentien (II) genannt.
Bei den Halogenierungsagentien (II) kann der additive Einsatz von Lewissäuren, wie sie beispielsweise oben aufgeführt wurden, ebenfalls vorteilhaft sein.

Nochmals weitere erfindungsgemäße Halogenierungsagentien sind organische O-X-Verbindung und Halogene X₂ im molaren Verhältnis von 0.5 : 1 bis 1 : 1, wie lod-aryl-dicarboxylate im molaren Verhältnis von 0.5 : 1 bis 1 : 1 mit einem Halogen X₂ so z. B. Iodbenzol-diacetat bzw. Bistrifluoracetoxy-iodbenzol und elementares Brom im molaren Verhältnis von 0.5 : 1 bis 1 : 1 oder lodbenzol-diacetat bzw. Bistrifluoracetoxy-iodbenzol und elementares Iod im molaren Verhältnis von 0.5 : 1 bis 1 : 1.
Diese Halogenierungsagentien werden nachfolgend Halogenierungsagentien (III) genannt.

Im erfindungsgemäßen Verfahren führt ein stöchiometrisches Verhältnis der Halogenierungsagentien (I), (II) oder (III) - bezogen auf den Gehalt an aktivem Halogen - zu den Verbindungen (III), (IV), (X), (XII), (XIV) oder (XVI) von 1 : 1 selektiv zu den Verbindungen (I), (II) mit n = 1 und (IX), (XI), (XIII), oder (XV) mit p = 1. Dies ist ein überraschendes und nicht vorhersehbares Ergebnis.

Im erfindungsgemäßen Verfahren führt ein stöchiometrisches Verhältnis der Halogenierungsagentien (I), (II) oder (III) - bezogen auf den Gehalt an aktivem Halogen - zu den Verbindungen (III), (IV), (VI), (VIII), (X), (XII), (XIV) oder (XVI) von 2 : 1 selektiv zu den Verbindungen (V) oder (VII) mit p = 1 und (I) oder (II) mit n = 2 und (IX), (XI), (XIII), oder (XV) mit p = 2. Dies ist ein überraschendes und nicht vorhersehbares Ergebnis.

Im erfindungsgemäßen Verfahren führt ein stöchiometrisches Verhältnis der Halogenierungsagentien (I), (II) oder (III) - bezogen auf den Gehalt an aktivem Halogen - zu den Verbindungen (III) oder (IV) von 3 : 1 selektiv zu den Verbindungen (I) oder (II) mit n = 3. Dies ist ein überraschendes und nicht vorhersehbares Ergebnis.

Im erfindungsgemäßen Verfahren führt ein stöchiometrisches Verhältnis der Halogenierungsagentien (I), (II) oder (III) - bezogen auf den Gehalt an aktivem Halogen - zu den Verbindungen (VI) oder (VIII) von 4 : 1 bis 1000:1 selektiv zu den Verbindungen (V) oder (VII) mit p = 2. Dies ist ein überraschendes und nicht vorhersehbares Ergebnis.

Die hier beschriebenen stöchiometrischen Verhältnisse sind bevorzugte Ausführungsformen der vorliegenden Erfindung, da sie zu einheitlich substituierten Produkten führen. Es ist selbstverständlich, daß leichte Abweichungen von den o. g. Verhältnissen immer noch zu guten bis akzeptablen Ergebnissen führen.

Erfindungsgemäß kann der Reaktionsmischung gegebenenfalls ein Reduktionsmittel im molaren Verhältnis von 0.1 : 1 bis 10 : 1 bezogen auf die Verbindungen (III), (IV), (VI), (VIII), (X), (XII), (XIV) oder (XVI) zugesetzt werden. Erfindungsgemäße Reduktionsmittel sind Hydrazin und Hydrochinone wie z.B. Hydrochinon oder Tetrachlorhydrochinon, 2,3-Dichlor-5,6-dicyanohydrochinon.

Erfindungsgemäße Reaktionsmedien sind protische oder aprotische, halogenfreie oder halogenierte Lösemittel so z.B. Alkohole wie Methanol, Ethanol, Propanol, Butanol, mehrwertige Alkohole wie Ethylenglykol oder Propylenglykol, Nitrile wie Acetonitril, Propionitril oder Benzonitril, Ether wie Diethylether, THF oder Dioxan, aromatische Kohlenwasserstoffe wie Benzonitril, Nitrobenzol oder Chlorbenzol, N,N-Dialkylamide wie Dimethylformamid, Dimethylacetamid oder N-Methylpyrrolidinon, Sulfoxide wie Dimethylsulfoxid, Sulfone wie Dimethylsulfon oder Sulfolan, halogenierte Kohlenwasserstoffe wie Dichlormethan, Trichlormethan, 1,1-Dichlorethan, 1,2-Dichlorethan, 1,1,2,2-Tetrachlorethan, bevorzugt sind aromatische oder chlorierte Lösemittel.

Erfindungsgemäß wird die Umsetzung im Temperaturbereich von - 78°C bis 150°C, bevorzugt bei 0°C bis 100°C, ganz bevorzugt bei 10°C bis 60°C durchgeführt.

Erfindungsgemäß liegt die Konzentration der Rhodium-haltigen bzw. Iridium-haltigen Edukte - Verbindungen (III), (IV), (VI), (VIII), (X), (XII), (XIV) oder (XVI) - im Bereich von 0.0005 mol/l bis 2 mol/l, besonders bevorzugt im Bereich von 0.002 mol/l bis 0.1 mol/l.

Erfindungsgemäß können die Rhodium-haltigen bzw. Iridium-haltigen Edukte gelöst oder suspendiert im Reaktionsmedium vorliegen.

Erfindungsgemäß wird die Reaktion innerhalb von 10 Minuten bis zu 100 Stunden durchgeführt, bevorzugt innerhalb von 1 h bis 40 h.

Mit den hier erläuterten Synthesemethoden lassen sich unter anderem die im folgenden dargestellten Beispiele für Verbindungen (I), (II), (Ia), (IIa), (V), (VII), (IX), (XI), (XIII) bzw. (XV) herstellen.

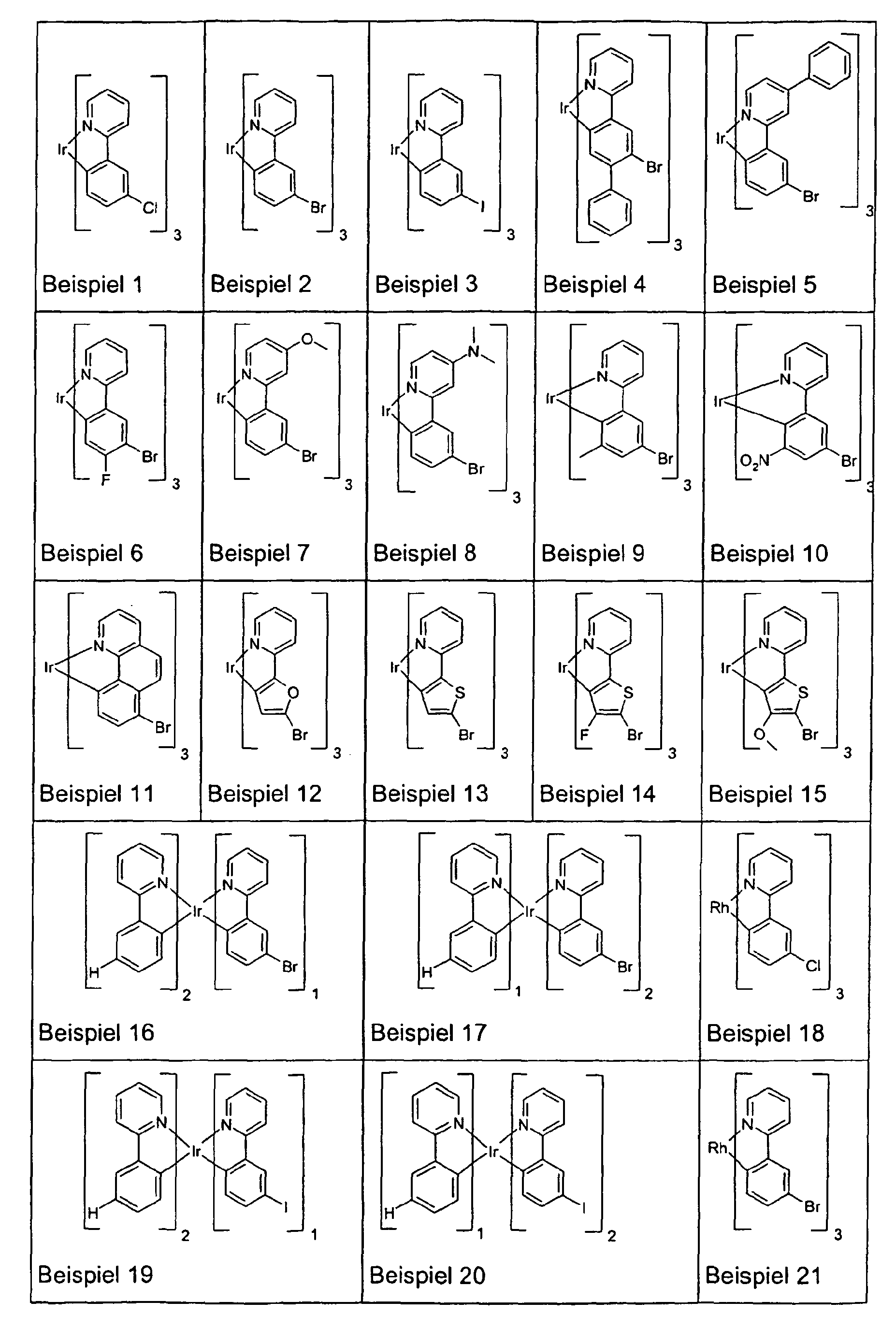

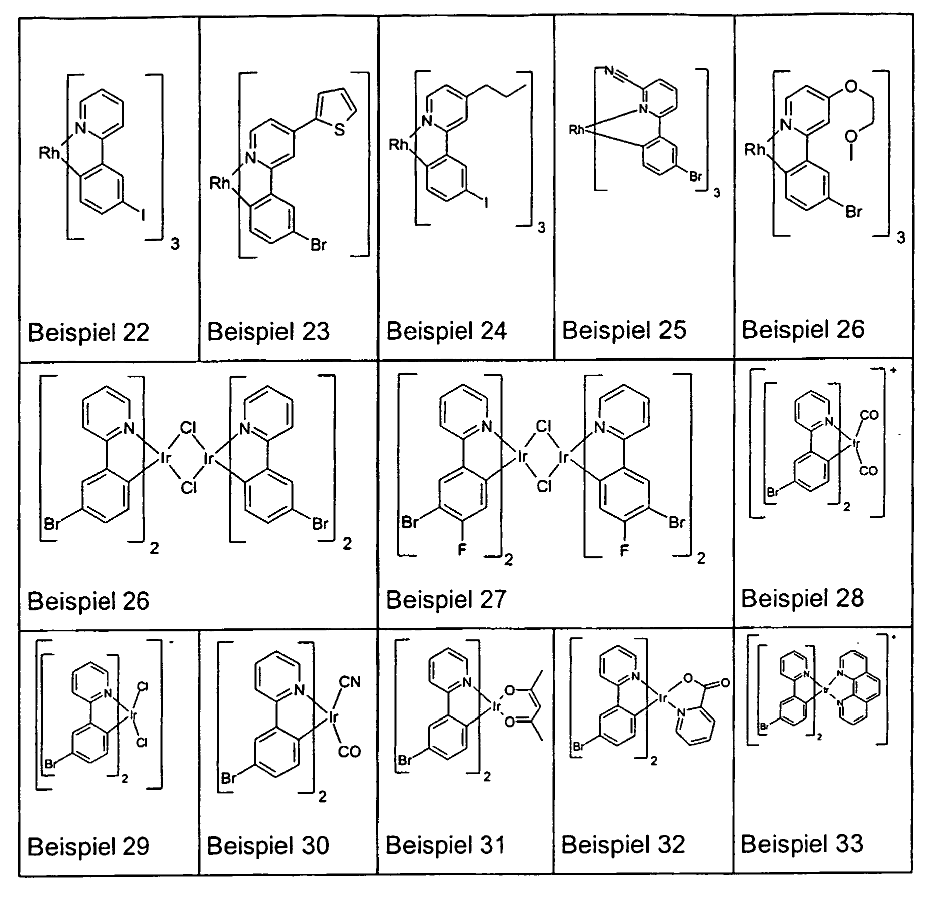

Die so erhaltenen erfindungsgemäßen Verbindungen können nun beispielsweise als Co-Monomere für Erzeugung entsprechender konjugierter oder auch teilkonjugierter Polymere Verwendung finden. So können sie u. a. in lösliche Polyfluorene (z. B. gemäß EP-A-842208 oder WO 00/22026), Poly-spirobifluorene (z. B. gemäß EP-A- 707020), Poly-para-phenylene (z. B. gemäß WO 92/18552), Poly-carbazole oder auch Polythiophene (z. B. gemäß EP-A-1028136) einpolymerisiert werden.

Die in EP-A-842208 und WO 00/22026 offenbarten Polyfluorene sind Bestandteil dieser Beschreibung.

Die in EP-A-707020 offenbarten Poly-spirobifluorene sind Bestandteil dieser Beschreibung.

Die in WO 92/18552 offenbarten Poly-para-phenylene sind Bestandteil dieser Beschreibung.

Die in EP-A-1028136 offenbarten Polythiophene sind Bestandteil dieser Beschreibung.

Weiterhin können die erfindungsgemäßen Verbindungen natürlich auch durch die beispielsweise o. g. Reaktionstypen weiter funktionalisiert werden, und so zu erweiterten niedermolekularen Rh- oder Ir-Komplexen umgesetzt werden. Hier ist als Beispiel die Funktionalisierung mit Arylboronsäuren gem. SUZUKI oder mit Aminen gem. HARTWIG-BUCHWALD zu nennen.

Die vorliegende Erfindung wird durch die folgenden Beispiele näher erläutert, ohne sie darauf beschränken zu wollen. Der Fachmann kann aus den Schilderungen ohne erfinderisches Zutun weitere erfindungsgemäße Komplexe herstellen bzw. das erfindungsgemäße Verfahren anwenden.

### 1. Synthese von symmetrisch und asymmetrisch funktionalisierten tris-orthometallierten Organo-Rhodium- bzw. Organo-Iridium-Verbindungen:

Die nachfolgenden Synthesen wurden - sofern nicht anders angegeben - an Luft unter Verwendung handelsüblicher Lösungsmittel durchgeführt. Die Edukte wurden von ALDRICH [Brom, Iod, N-Chlor-succinimid, N-Brom-succinimid, N-Ethyl-di-*iso-*propylamin, Eisen(III)chlorid, lodbenzol-diacetat, Hydrochinon] bezogen. Vor der Verwendung der N-Halogen-Imide und des lodbenzol-diacetats wurde der Gehalt an aktivem Halogen jodometrisch bestimmt [analog zu: K. W. Rosenmund, W. Kuhnhenn, Ber. 1923, 56, 1262]. *fac*-Tris[2-(2-pyridinyl-κN)phenyl-κC]-iridium(III), *fac*-Tris[2-(2-pyridinyl-κN)4-fluorphenyl-κC]-iridium(III) und ) *fac*-Tris[2-(2-pyridinyl-κN)-4-methoxyphenyl-κC]-iridium(III) wurden wie in der nicht offengelegten Anmeldung DE 10104426.7 beschrieben dargestellt. Tetrakis[(2-pyridinyl-κN)phenyl-κC][di-µ-chloro]-di-iridium(III) wurde nach Literaturmethoden (S. Sprouse, K. A. King, P. J. Spellane, R. J. Watts J. Am. Chem. Soc. 1984, 106, 6647) dargestellt.

Die Zuordnung der ¹H-NMR-Signale wurden zum Teil durch H-H-COSY-Spektren, die der ¹³C{¹H}-NMR-Signale jeweils über DEPT-1 35-Spektren abgesichert. Numerierungsschema für die Zuordnung der ¹H-NMR-Signale [nach: C. Coudret, S. Fraysse, J.-P- Launay, Chem. Commun., 1998, 663-664]:

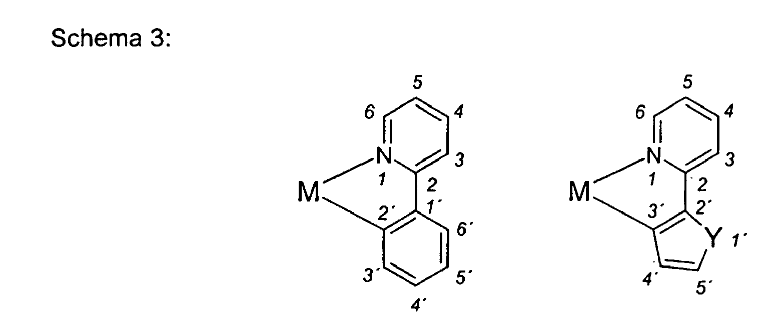

### Beispiel 1: fac-Tris[2-(2-pyridinyl-κN)(5-chlorphenyl)-κC]-iridium(III)

4.407 g (33.0 mmol) N-Chlor-succinimid wurden unter Lichtausschluß zu einer gut gerührten Lösung von 6.548 g (10.0 mmol) *fac*-Tris[2-(2-pyridinyl-κN)phenyl-κC]-iridium(III) in 1500 ml Dichlormethan gefügt. Die Reaktionsmischung wurde weitere 20 h bei Raumtemperatur gerührt. Nach Einengen im Vakuum auf ein Volumen von 50 ml wurde die Lösung mit 500 ml Ethanol versetzt. Anschließend wurde der mikrokristalline Niederschlag abfiltriert (P4), dreimal mit 50 ml Ethanol gewaschen und dann im Vakuum (60°C, 10⁻⁴ mbar) getrocknet. Die Ausbeute - bei einer Reinheit von > 99.7% nach ¹H-NMR - betrug 7.210 - 7.356 entsprechend 95.1 - 97.0 %.
¹HNMR (DMSO-d6): [ppm] = 8.32 (br. dd, 1 H, ³J_{HH} = 8.4 Hz, ⁴J_{HH} = 1.3 Hz , H6), 7.91 (d, 1 H, ⁴J_{HH} = 2.0 Hz, H6'), 7.87 (ddd, 1 H, ³J_{HH} = 8.4 Hz, ³J_{HH} = 8.4 Hz, ⁴J_{HH} = 1.6 Hz, H5), 7.42 (dd, 1 H, ³J_{HH} = 5.4 Hz, ⁴J_{HH} = 1.6 Hz, H3), 7.26 (ddd, 1 H, ³J_{HH} = 8.4 Hz, ³J_{HH} = 5.4 Hz, ⁴J_{HH} = 1.3 Hz , H4), 6.87 (dd, 1 H, ³J_{HH} = 8.0 Hz, ⁴J_{HH} = 2.0 Hz, H4'), 6.63 (d, 1 H, ³J_{HH} = 8.0 Hz, H3').

### Beispiel 2: fac-Bis[2-(2-pyridinyl-κN)phenyl-κC]-[2-(2-pyridinyl-κN) (5-bromphenyl)-κC]-iridium(III)

Unter Lichtausschluß wurde zu einer gut gerührten Lösung von 6.548 g (10.0 mmol) *fac*-Tris[2-(2-pyridinyl-κN)phenyl-κC]-iridium(III) in 1500 ml Dichlormethan eine Lösung von 1.816 g (10.2 mmol) N-Brom-succinimid (Gehalt an aktivem Brom: 98 %) in 100 ml Dichlormethan tropfenweise während 1 h gefügt. Die Lösung wurde weitere 15 h bei Raumtemperatur gerührt. Nach Einengen im Vakuum auf ein Volumen von 100 ml wurde die Lösung mit 500 ml Ethanol versetzt. Anschließend wurde der mikrokristalline Niederschlag abfiltriert (P4), dreimal mit 50 ml Ethanol gewaschen und dann im Vakuum (60°C, 10⁻⁴ mbar) getrocknet. Die Ausbeute - bei einer Reinheit von > 99.7% nach ¹H-NMR - betrug 7.138 - 7.197 g entsprechend 97.2 - 98.1 %.
¹HNMR (DMSO-d6): [ppm] = 8.25 - 8.22 (m, 1 H), 8.16 - 8.12 (m, 2 H), 7.95 - 7.93 (m, 1 H), 7.86 - 7.74 (m, 5 H), 7.52 - 7.45 (m, 3 H), 7.21 - 7.17 (m, 1 H), 7.16 - 7.11 (m, 2 H), 6.89 - 6.78 (m, 3 H), 6.75 - 6.53 (m, 5 H).

### Beispiel 3: fac-[2-(2-pyridinyl-κN)phenyl-κC]-bis[2-(2-pyridinyl-κN) (5-bromphenyl)-κC]-iridium(III)

Unter Lichtausschluß wurde zu einer gut gerührten Lösung von 6.548 g (10.0 mmol) *fac*-Tris[2-(2-pyridinyl-κN)phenyl-κC]-iridium(III) in 1500 ml Dichlormethan eine Lösung von 3.632 g (20.4 mmol) N-Brom-succinimid (Gehalt an aktivem Brom: 98 %) in 100 ml Dichlormethan tropfenweise während 1 h gefügt. Die Lösung wurde weitere 15 h bei Raumtemperatur gerührt. Nach Einengen im Vakuum auf ein Volumen von 100 ml wurde die Lösung mit 500 ml Ethanol versetzt. Anschließend wurde der mikrokristalline Niederschlag abfiltriert (P4), dreimal mit 50 ml Ethanol gewaschen und dann im Vakuum (60°C, 10⁻⁴ mbar) getrocknet. Die Ausbeute - bei einer Reinheit von > 99.7% nach ¹H-NMR - betrug 7.858 - 7.907 entsprechend 96.7 - 97.3 %.
¹HNMR (DMSO-d6): [ppm] = 8.25 - 8.22 (m, 2 H), 8.16 - 8.12 (m, 1 H), 7.95 - 7.93 (m, 2 H), 7.86 - 7.74 (m, 4 H), 7.52 - 7.45 (m, 3 H), 7.21 - 7.17 (m, 2 H), 7.16 - 7.11 (m, 1 H), 6.89 - 6.78 (m, 3 H), 6.75 - 6.53 (m, 4 H).

### Beispiel 4: fac-Tris[2-(2-pyridinyl-κN)(5-bromphenyl)-κC]-iridium(III)

7.120 g (40.0 mmol) N-Brom-succinimid wurden unter Lichtausschluß zu einer gut gerührten Lösung von 6.548 g (10.0 mmol) *fac*-Tris[2-(2-pyridinyl-κ)phenyl-κC]-iridium(III) in 1500 ml Dichlormethan gefügt. Nach ca. 1 h fiel das Produkt als gelber, mikrokristalliener Niederschlag aus der gelben Reaktionslösung aus. Die Suspension wurde weitere 20 h bei Raumtemperatur gerührt. Nach Einengen der Suspension im Vakuum auf ein Volumen von 200 ml wurde der mikrokristalline Niederschlag abfiltriert (P4), zehn mal mit 100 ml Wasser und einmal mit 100 ml Ethanol gewaschen und anschließend im Vakuum (60°C, 10⁻⁴ mbar) getrocknet. Die Ausbeute - bei einer Reinheit von > 99.7% nach ¹H-NMR - betrug 8.520 - 8.610 g entsprechend 95.5 - 96.5 %.
¹HNMR (DMSO-d6): [ppm] = 8.26 (br. dd, 1 H, ³J_{HH} = 8.4 Hz, ⁴J_{HH} = 1.3 Hz , H6), 7.96 (d, 1 H, ⁴J_{HH} = 2.0 Hz, H6'), 7.85 (ddd, 1 H, ³J_{HH} = 8.4 Hz, ³J_{HH} = 8.4 Hz, ⁴J_{HH} = 1.6 Hz, H5), 7.49 (dd, 1 H, ³J_{HH} = 5.4 Hz, ⁴J_{HH} = 1.6 Hz, H3), 7.20 (ddd, 1 H, ³J_{HH} = 8.4 Hz, ³J_{HH} = 5.4 Hz, ⁴J_{HH} = 1.3 Hz , H4), 6.89 (dd, 1 H, ³J_{HH} = 8.0 Hz, ⁴J_{HH} = 2.0 Hz, H4'), 6.53 (d, 1 H, ³J_{HH} = 8.0 Hz, H3').
¹³C{¹H}NMR (DMSO-d6): [ppm] = 163.8 (q), 158.1 (q), 147.2 (t), 146.8 (q), 138.0 (t), 137.6 (t), 131.8 (t), 126.7 (t), 123.9 (t), 120.0 (t), 113.5 (q).

### Beispiel 5: fac-Tris[2-(2-pyridinyl-κN)(5-bromphenyl)κC]-iridium(III)

Unter Lichtausschluß wurden zu einer gut gerührten Lösung von 6.548 g (10.0 mmol) *fac*-Tris[2-(2-pyridinyl-κN)phenyl-κC]-iridium(III) in 1500 ml Dichlormethan 12.925 g = 17.42 ml (100 mmol) N-Ethyl-di-iso-propylamin, 7.991 g = 2.58 ml (50 mmol) Brom und 16.2 mg (0.1 mmol) wasserfreies Eisen(III)chlorid gefügt. Nach ca. 6 h fiel das Produkt als gelber, mikrokristalliener Niederschlag aus der rotbraunen Reaktionslösung aus. Die Suspension wurde weitere 16 h bei Raumtemperatur gerührt. Nach Einengen der Suspension im Vakuum auf ein Volumen von 200 ml wurde der mikrokristalline Niederschlag abfiltriert (P4), zehn mal mit 100 ml Wasser und dreimal mit 100 ml Ethanol gewaschen und anschließend im Vakuum (60°C, 10⁻⁴ mbar) getrocknet. Die Ausbeute - bei einer Reinheit von > 99.5% nach ¹H-NMR - betrug 8.340 - 8.481 entsprechend 93.6 - 95.1 %.
¹HNMR- und ¹³C{¹H}NMR-spektroskopische Daten siehe Beispiel 4.

### Beispiel 6: fac-Tris[2-(2-pyridinyl-κN)(5-iodphenyl)-κC]-iridium(III)

Unter Lichtausschluß wurden zu einer gut gerührten Lösung von 6.548 g (10.0 mmol) *fac*-Tris[2-(2-pyridinyl-κN)phenyl-κC]-iridium(III) in 1500 ml Dichlormethan 10.152 g (40 mmol) Iod und 6.442 g (20 mmol) Iodbenzol-diacetat gefügt. Nach ca. 24 h fiel das Produkt als gelber, mikrokristalliener Niederschlag aus der rotbraunen Reaktionslösung aus. Die Suspension wurde weitere 16 h bei Raumtemperatur gerührt. Nach Einengen der Suspension im Vakuum auf ein Volumen von 100 ml wurde diese mit 500 ml Ethanol versetzt, anschließend wurde der mikrokristalline Niederschlag abfiltriert (P4), dreimal mit 100 ml Ethanol dreimal mit 100 ml Wasser und dreimal mit 100 ml Ethanol gewaschen und im Vakuum (60°C, 10⁻⁴ mbar) getrocknet. Die Ausbeute - bei einer Reinheit von > 99.7% nach ¹H-NMR - betrug 9.819 - 9.995 g entsprechend 95.1 - 96.8 %.
¹HNMR (DMSO-d6): [ppm] = 8.22 (br. d, 1 H, ³J_{HH} = 8.4 Hz, H6), 8.06 (d, 1 H, ⁴J_{HH} = 2.0 Hz, H6'), 7.83 (br. m, 1 H, H5), 7.45 (br. d, 1 H, ³J_{HH} = 5.4 Hz, H3), 7.40 (br. m, 1 H, H4), 7.02 (dd, 1 H, ³J_{HH} = 8.0 Hz, ⁴J_{HH} = 2.0 Hz, H4'), 6.41 (d, 1 H, ³J_{HH} = 8.0 Hz, H3').

### Beispiel 7: fac-Tris[2-(2-pyridinyl-κN)(5-iodphenyl)-κC]-iridium(III)

Unter Lichtausschluß wurden zu einer gut gerührten Lösung von 6.548 g (10.0 mmol) *fac*-Tris[2-(2-pyridinyl-κN)phenyl-κC]-iridium(III) in 1500 ml Dichlormethan 13.500 g (60 mmol) N-Iodsuccinimid und 16 mg (0.1 mmol) Eisen(III)chlorid gefügt. Nach ca. 48 h fiel das Produkt als gelber, mikrokristalliener Niederschlag aus der gelben Reaktionslösung aus. Die Suspension wurde weitere 16 h bei Raumtemperatur gerührt. Nach Einengen der Suspension im Vakuum auf ein Volumen von 100 ml wurde diese mit 500 ml Ethanol versetzt, anschließend wurde der mikrokristalline Niederschlag abfiltriert (P4), dreimal mit 100 ml Ethanol dreimal mit 100 ml Wasser und dreimal mit 100 ml Ethanol gewaschen und im Vakuum (60°C, 10⁻⁴ mbar) getrocknet. Die Ausbeute - bei einer Reinheit von > 99.5% nach ¹H-NMR - betrug 9.427 - 9.657 entsprechend 91.3 - 93.5 %. ¹HNMR-NMR-spektroskopische Daten siehe Beispiel 6.

### Beispiel 8: fac-Tris[2-(2-pyridinyl-κN)-5-brom-4-fluorphenyl-κC]-iridium(III)

Unter Lichtausschluß wurde zu einer gut gerührten Lösung von 7,082 g (10.0 mmol) *fac*-Tris[2-(2-pyridinyl-κN)4-fluorphenyl-κC]-iridium(III) in 1200 ml Dichlormethan eine Lösung von 5,323 g (30.2 mmol) N-Brom-succinimid (Gehalt an aktivem Brom: 98 %) in 100 ml Dichlormethan tropfenweise während 1 h zugefügt. Die Lösung wurde weitere 15 h bei Raumtemperatur gerührt. Nach Einengen im Vakuum auf ein Volumen von 100 ml wurde die Lösung mit 500 ml Ethanol versetzt. Anschließend wurde der mikrokristalline Niederschlag abfiltriert (P4), dreimal mit 50 ml Ethanol gewaschen und dann im Vakuum (60°C, 10⁻⁴ mbar) getrocknet. Die Ausbeute - bei einer Reinheit von > 99.7% nach ¹H-NMR - betrug 8.916 entsprechend 94.3 %. ¹HNMR (DMSO-d6): [ppm] = 8.29 (d, 1 H, ³J_{HH}= 8.0 Hz, H6), 8,18 (d, 1 H, ⁴J_{HF}= 6.7 Hz, H6'), 7,89 (br. dd, 1 H, ³J_{HH}= 8.0 Hz, ³J_{HH}= 6.0 Hz, H5), 7.48 (d, 1H, ³J_{HH}= 6.0 Hz, H3), 7,23 (br. dd, 1H, ³J_{HH}= 6.0 Hz, ³J_{HH}= 6.0 Hz, H4), 6.27 (d, 1H, ³J_{HF}= 9.7 Hz, H3').

### Beispiel 9: fac-Tris[2-(2-pyridinyl-κN)-5-brom-4-methoxyphenyl-κC]-iridium(III)

7.120 g (40.0 mmol) N-Brom-succinimid wurden unter Lichtausschluß zu einer gut gerührten Lösung von 7.449 g (10.0 mmol) *fac*-Tris[2-(2-pyridinyl-κN)-4-methoxyphenyl-κC]-iridium(III) in 1500 ml Dichlormethan gefügt. Die Lösung wurde weitere 20 h bei Raumtemperatur gerührt. Nach Zugabe von 0.3 ml Hydrazinhydrat und Einengen der Suspension im Vakuum auf ein Volumen von 200 ml wurde diese mit 500 ml Ethanol versetzt und 20 h bei Raumtemperatur gerührt. Der ausgefallene mikrokristalline Niederschlag wurde abfiltriert (P4), zehnmal mit 100 ml Wasser /Ethanol (1 : 1 vv) und einmal mit 100 ml Ethanol gewaschen und anschließend im Vakuum (60°C, 10⁻⁴ mbar) getrocknet. Die Ausbeute - bei einer Reinheit von > 99.7% nach ¹H-NMR - betrug 9.190 entsprechend 93.6 %.
¹HNMR (DMSO-d6): [ppm] = 8.11 (d, 1 H, ³J_{HH}= 7.8 Hz, H6), 7.96 (s, 1 H, H6'), 7.78 (br. dd, 1 H, ³J_{HH}= 7.8 Hz, ³J_{HH}= 6.0 Hz, H5), 7.48 (d, 1H, ³J_{HH}= 6.0 Hz, H3), 7.21 (br. dd, 1H, ³J_{HH}= 6.0 Hz, ³J_{HH}= 6.0 Hz, H4), 6.35 (s, 1 H, H3').

### Beispiel 10: Tetrakis[(2-pyridinyl-κN)(5-bromphenyl)-κC][di-p-chloro]-di-iridium(III)

Unter Lichtausschluß wurde zu einer gut gerührten Lösung von 10.721 g (10.0 mmol) Tetrakis[(2-pyridinyl-κN)phenyl-κC][di-µ-chloro]-di-iridium(II I) und 1.081 g (10 mmol) Hydrochinon in 1200 ml Dichlormethan eine Lösung von 10.680 g (60 mmol) N-Brom-succinimid (Gehalt an aktivem Brom: 98 %) zugefügt. Die Lösung wurde weitere 15 h bei Raumtemperatur gerührt. Nach Einengen im Vakuum auf ein Volumen von 200 ml wurde die Lösung mit 2000 ml Ethanol versetzt. Anschließend wurde der mikrokristalline Niederschlag abfiltriert (P4), dreimal mit 50 ml Ethanol gewaschen und dann im Vakuum (60°C, 10⁻⁴ mbar) getrocknet. Die Ausbeute - bei einer Reinheit von > 99.0 % nach ¹H-NMR - betrug 12.68 entsprechend 91.0 %. ¹H-NMR (CDCl₃): [ppm] = 9,11 (d, 1 H, ³J_{HH}= 5,7 Hz, H6), 7.79 (d, 1 H, ³J_{HH}= 7.6 Hz, H3), 7.72 (br. dd, 1 H, H5), 7.54 (d, 1H, ⁴J_{HH}= 2.15 Hz, H6'), 6.74(br. dd, 1H, H4), 6.62 (dd, 1H, ⁴J_{HH}= 2.15 Hz, ³J_{HH}= 8.35 Hz, H4'), 5.65 (d, 1 H, ³J_{HH}= 8.35 Hz, H3').

## Patentansprüche

1. Verbindung gemäß Formel (I), (II), (Ia), (IIa), (V), (VII), (IX), (XI), (XIII) und (XV), 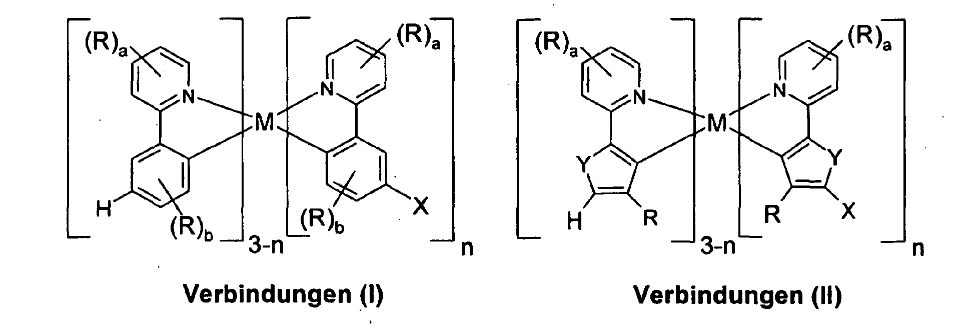 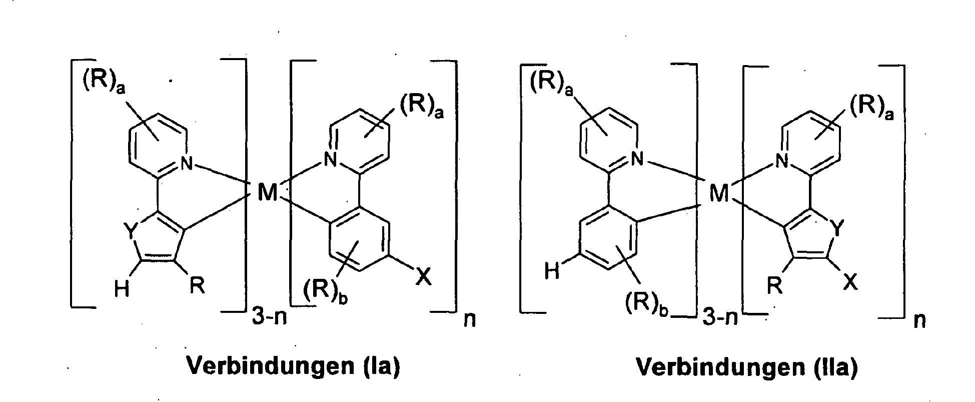 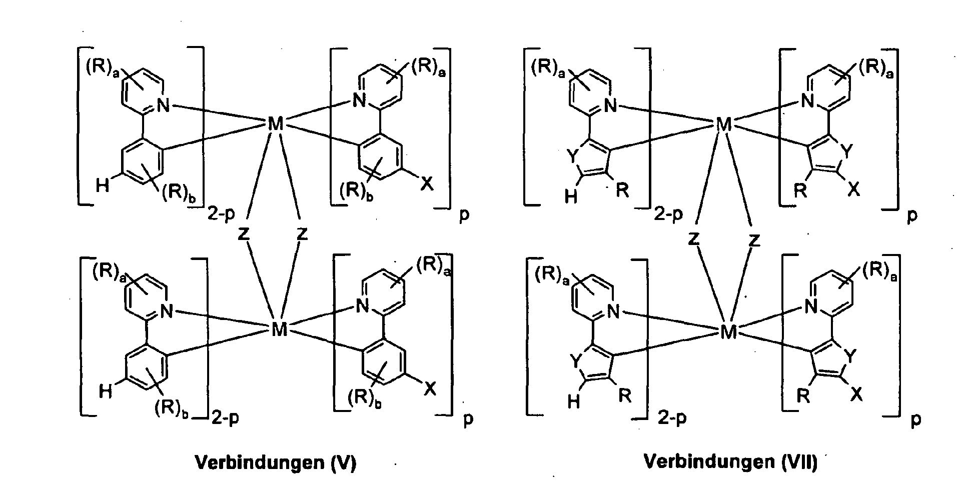 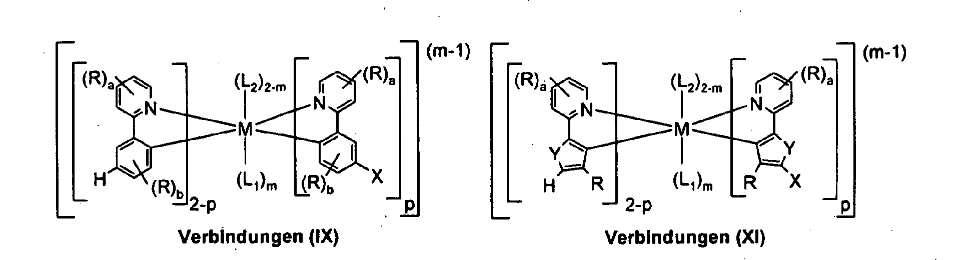 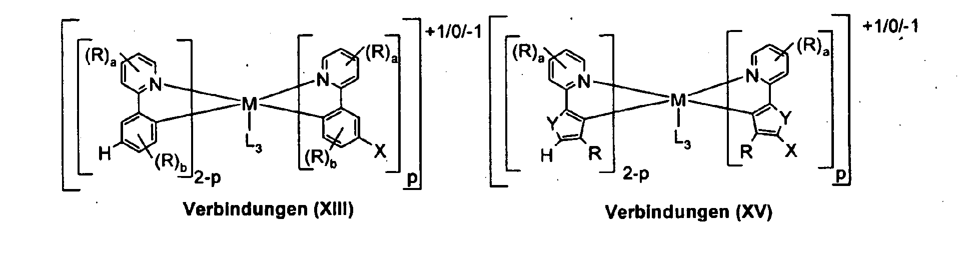 wobei die Symbole und Indizes folgende Bedeutung haben:
M ist gleich Rh, Ir;
X ist gleich oder verschieden Cl, Br, I;
Y ist gleich oder verschieden O, S, Se;
Z ist gleich F, Cl, Br, I, O-R¹, S-R¹, N(R¹)₂;
R ist gleich oder verschieden bei jedem Auftreten H, F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR² - ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
R¹ und R² sind gleich oder verschieden, H oder ein aliphatischer oder aromatischer Kohlenwasserstoffrest mit 1 bis 20 C-Atomen;
L₁ ist ein neutraler, einzähniger Ligand;
L₂ ist ein monoanionischer, einzähniger Ligand;
L₃ ist ein neutaler oder mono- oder dianionischer zweizähniger Ligand;
a ist gleich oder verschieden 0, 1, 2, 3 oder 4, bevorzugt 0, 1 oder 2;
b ist gleich oder verschieden 0, 1, 2 oder 3, bevorzugt 0 oder 1;
n ist 1, 2 oder 3;
m ist 0, 1 oder 2;
p ist 1 oder 2;
wobei die folgende Verbindung von der Erfindung ausgenommen ist:

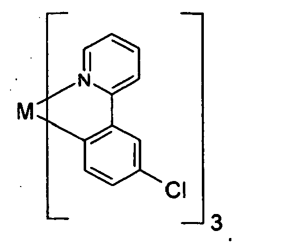

2. Verbindungen gemäß Anspruch 1 **dadurch gekennzeichnet, daß** L₁ Kohlenmonoxid, ein Isonitil wie z.B. tert-Butyl-isonitril, Cyclohexylisonitril, Adamantylisonitril , ein Amin wie z.B. Trimethylamin, Triethylamin, Morpholin, ein Phosphin wie z. B. Trifluorphosphin, Trimethylphosphin, Tricyclohexylphosphin, Tri-tert-butylphosphin, Triphenylphosphin, Tris(pentafluorphenyl)phosphin, ein Phosphit wie z.B. Trimethylphosphit, Triethylphosphit, ein Arsin wie z.B. Trifluorarsin, Trimethylarsin, Tricyclohexylarsin, Tri-tert-butylarsin, Triphenylarsinin, Tris(pentafluorphenyl)arsin, ein Stibin wie z.B. Trifluorstibin, Trimethylstibin, Tricyclohexylstibin, Tri-tert-butylstibin, Triphenylstibin, Tris(pentafluorphenyl)stibin oder ein stickstoffhaltiger Heterocyclus wie Pyridin, Pyridazin, Pyrazin, Triazin, ist.

3. Verbindungen gemäß Anspruch 1 **dadurch gekennzeichnet, daß** L₂ ein Halogenid, Cyanid, Cyanat, Iso-cyanat, Thiocyanat, Iso-thiocyanat, ein Alkoholat wie z.B. Methanolat, Ethanolat, Propanolat, iso-Propanolat, *tert*-Butylat, Phenolat, ein Thioalkoholat wie z.B. Methanthiolat, Ethanthiolat, Propanthiolat, *iso*-Propanthiolat, *tert*-Thiobutylat, Thiophenolat, ein Amid wie z.B. Dimethylamid, Diethylamid, Di-isopropylamid, Pyrrolid, Morpholid, ein Carboxyalat wie z.B. Acetat, Trifluoracetat, Propionat, Benzoat oder ein anionischer stickstoffhaltiger Heterocyclus wie Pyrrolid, Imidazolid, Pyrazolid, ist.

4. Verbindungen gemäß Anspruch 1 **dadurch gekennzeichnet, daß** L₃ ein Diamin wie z. B. Ethylendiamin, N,N,N',N'-Tetramethylethylendiamin, Propylendiamin, N,N,N',N'-Tetramethylpropylendiamin, cis-, trans-Diaminocyclohexan, cis-, trans-N,N,N',N'-Tetramethyldiaminocyclohexan, ein Imin wie z.B. 2[(1-(Phenylimino)-ethyl]pyridin, 2[(1-(2-Methylphenylimino)ethyl]pyridin, 2[(1-(2,6-Di-*iso*-propylphenylimino)ethyl]pyridin, 2[(1-(Methylimino)ethyl]pyridin, 2[(1-(ethylimino)ethyl]pyridin, 2[(1-(iso-Propylimino)ethyl]pyridin, 2[(1-(*Tert*-Butylimino)ethyl]pyridin, ein Dimin wie z.B. 1,2-Bis(methylimino)ethan, 1,2-Bis(ethylimino)ethan, 1,2-Bis(*iso*-propylimino)ethan, 1,2-Bis(*tert*-butylimino)ethan, 2,3-Bis(methylimino)butan, 2,3-Bis(ethylimino)butan, 2,3-Bis(*iso*-propylimino)butan, 2,3-Bis(*tert*-butylimino)butan, 1,2-Bis(phenyimino)-ethan, 1,2-Bis(2-methylphenyimino)ethan, 1,2-Bis(2,6-di-*iso*-propylphenyimino)ethan, 1,2-Bis(2,6-di-*tert*-butylphenyimino)ethan, 2,3-Bis(phenyimino)butan, 2,3-Bis(2-methylphenyimino)butan, 2,3-Bis(2,6-di-*iso*-propylphenyimino)butan, 2,3-Bis(2,6-di-*tert*-butylphenyimino)butan, ein Heterocyclus enthaltend zwei Stickstoffatome wie z.B. 2,2'-Bipyridin, o-Phenanthrolin, ein Diphosphin wie z.B. Bis(diphenylphosphino)-methan, Bis(diphenylposphino)ethan, Bis(diphenylphosphino)propan, wie Bis(dimethylphosphino)methan, wie Bis(dimethylposphino)ethan, Bis(dimethylphosphino)-propan, wie Bis(diethylposphino)methan, wie Bis(diethylposphino)ethan, Bis(diethylphosphino)propan, Bis(di-*tert*-butylphosphino)methan, wie Bis(di-*tert*-butylphosphino)ethan, Bis(*tert*-butylphosphino)propan, ein 1,3-Diketonat abgeleitet von 1,3-Diketon wie z.B. Acetylaceton, Benzoylaceton, 1,5-Diphenylacetylaceton, Dibenzolymethan, Bis(1,1,1-tri-fluoracetyl)methan, ein 3-Ketonat abgeleitet von 3-Ketoestern wie z.B. Acetessigsäureethylester, ein Carboxylat abgeleitet von Aminocarbonsäuren wie z.B. Pyridin-2-carbonsäure, Chinolin-2-carbonsäure, Glycin, Dimethylglycin, Alanin, Dimethylaminoalanin, ein Salicyliminat abgeleitet von Salicyliminen wie z.B. Methylsalicylimin, Ethylsalicylimin, Phenylsalicylimin, ein Dialkoholat abgeleitet von Dialkoholen wie z.B. Ethylenglykol, 1,3-Propylenglykol, ein Ditholat abgeleitet von Dithiolen wie z.B. 1,2-Ethylendithiolat, 1,3-Propylendithiolat ist.

5. Verfahren zur Herstellung der Verbindungen definiert in Anspruch 1, durch Umsetzung der Verbindungen (III) bzw. (IV) bzw. (VI) bzw. (VIII) bzw. (X) bzw. (XII) bzw. (XIV) bzw. (XVI), 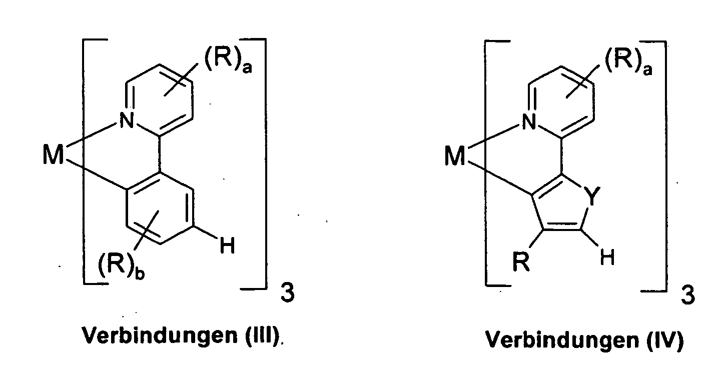 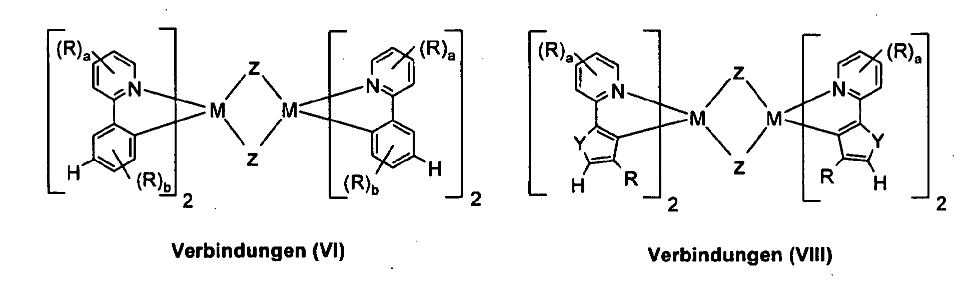 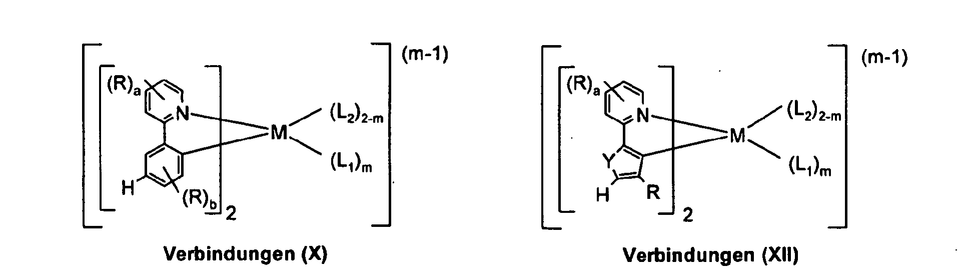 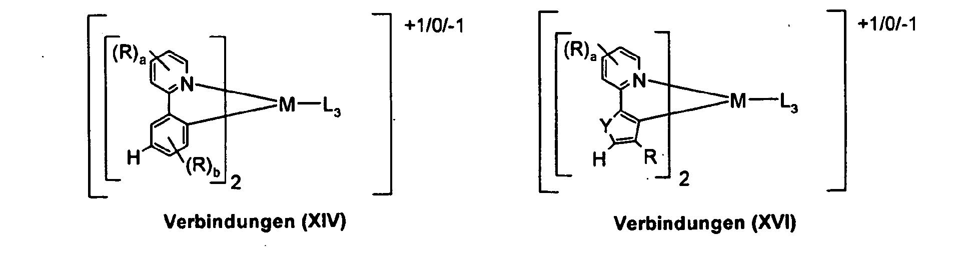 worin M und die Reste und Indizes Y, Z, R, L₁, L₂, L₃, a, b und m die in Anspruch 1 genannten Bedeutungen haben, mit Halogenierungsagentien.

6. Verfahren gemäß Anspruch 5, **dadurch gekennzeichnet, daß** als Halogenierungsagenz ein Halogen X₂ oder ein Interhalogen X-X und eine Base im Verhältnis 1 : 1 bis 1 : 100 oder ein organischer Bromkomplex, wie Pyridiniumperbromid, und jeweils gegebenenfalls eine Lewis-Säure im Verhältnis (Halogen zu Lewissäure) von 1 : 0.1 bis 1 : 0.0001 verwendet wird.

7. Verfahren gemäß Anspruch 6, **dadurch gekennzeichnet, daß** als Halogen oder Interhalogen Chlor, Brom oder Iod bzw. Chlorfluorid, Bromfluorid, Iodfluorid, Bromchlorid, lodchlorid oder lodbromid verwendet wird.

8. Verfahren gemäß Anspruch 6 oder 7, **dadurch gekennzeichnet, daß** als Base organischen Amine, wie Triethylamin, Tri-*n*-butylamin, Diisopropyl-ethylamin, Morpholin, N-Methylmorpholin und Pyridin, oder Salze von Carbonsäuren wir Natriumacetat, Natriumpropionat, Natruimbenzoat, oder anorganische Basen wie Natrium- oder Kalium-phosphat oder -hydrogenphosphat, Natrium- oder Kaliumhydrogencarbonat, Natrium- oder Kaliumcarbonat verwendet werden.

9. Verfahren gemäß einem oder mehrerer der Ansprüche 6 bis 8, **dadurch gekennzeichnet, daß** eine Lewis-Säure wie Bortrifluorid, Bortrifluoridetherat, Bortrichlorid, Bortribromid, Bortrijodid, Aluminiumtrichlorid; Aluminiumtribromid, Aluminiumtriodid, Eisen(III)chlorid, Eisen(III)bromid, Zink(II)chlorid, Zink(II)bromid, Zinn(IV)chlorid, Zinn(IV)bromid, Phosphorpentachlorid, Arsenpentachlorid und Antimonpentachlorid, verwendet wird.

10. Verfahren gemäß Anspruch 5, **dadurch gekennzeichnet, daß** als Halogenierungsagenz eine organische N-X-Verbindung verwendet wird.

11. Verfahren gemäß Anspruch 10, **dadurch gekennzeichnet, daß** als organische N-X-Verbindung 1-(Chlormethyl)-4-fluor-1,4-diazonia-bicyclo-[2.2.2]-octan-bis-(tetrafluoroborat), N-Halogen-carbonsäureamide, wie N-Chlor-, N-Brom und N-Iodacetamid, N-Chlor-, N-Brom- und N-Iod-propionamid, N-Chlor-, N-Brom und N-Iodbenzoesäureamid, oder N-Halogen-carbonsäureimide, wie N-Chlor-, N-Brom- und N-lod-succinimid, N-Chlor-, N-Brom und N-Iod-phthalimid, oder N-Dihalogensulfonsäureamid, , wie Benzolsulfo-N-dibromamid, oder N-Halogen-sulfonsäureamidsalze, wie Chloramin B oder T, verwendet wird.

12. Verfahren gemäß Anspruch 5, **dadurch gekennzeichnet, daß** als Halogenierungsagenz organische O-X-Verbindungen und Halogene X₂ im molaren Verhältnis von 0.5 : 1 bis 1 : 1 verwendet werden.

13. Verfahren gemäß Anspruch 12, **dadurch gekennzeichnet, daß** als organische O-X-Verbindungen lod-aryl-dicarboxylate, wie Iodbenzol-diacetat oder Bistrifluoracetoxy-iodbenzol verwendet werden.

14. Verfahren gemäß Anspruch 5, **dadurch gekennzeichnet, daß** ein stöchiometrisches Verhältnis der Halogenierungsagentien gemäß den Ansprüchen 11, 15 oder 17 - bezogen auf den Gehalt an aktivem Halogen - zu den Verbindungen (III), (IV), (X), (XII), (XIV) oder (XVI) von 1 : 1 verwendet wird.

15. Verfahren gemäß Anspruch 5, **dadurch gekennzeichnet, daß** ein stöchiometrisches Verhältnis der Halogenierungsagentien gemäß den Ansprüchen 11, 15 oder 17 - bezogen auf den Gehalt an aktivem Halogen - zu den Verbindungen (III), (IV), (VI), (VIII), (X), (XII), (XIV) oder (XVI) von 2 : 1 verwendet wird.

16. Verfahren gemäß Anspruch 5, **dadurch gekennzeichnet, daß** ein stöchiometrisches Verhältnis der Halogenierungsagentien gemäß den Ansprüchen 11, 15 oder 17 - bezogen auf den Gehalt an aktivem Halogen - zu den Verbindungen (III) oder (IV) von 3 : 1 verwendet wird.

17. Verfahren gemäß Anspruch 5, **dadurch gekennzeichnet, daß** ein stöchiometrisches Verhältnis der Halogenierungsagentien gemäß den Ansprüchen 11, 15 oder 17 - bezogen auf den Gehalt an aktivem Halogen - zu den Verbindungen (VI) oder (VIII) im Bereich von 4 : 1 bis 1000 : 1 verwendet wird.

18. Verbindungen gemäß Anspruch 1, **dadurch gekennzeichnet, daß** ihre Reinheit (mittels 1H-NMR bzw. HPLC bestimmt) mehr als 99% beträgt.

19. Konjugierte oder teilkonjugierte Polymere enthaltend eine oder mehrere Verbindungen der Formel (I) und/oder (II) 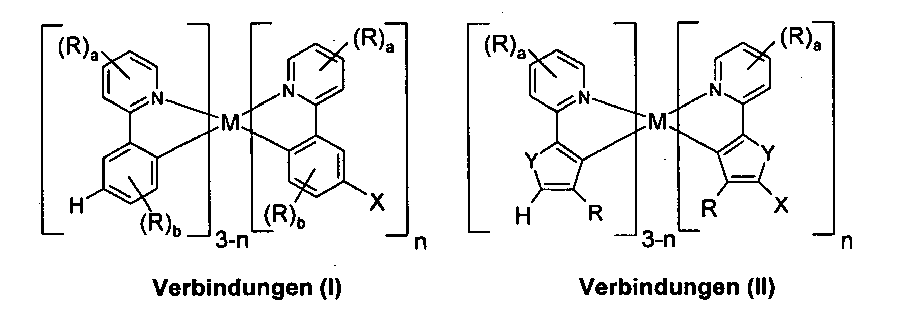 und/oder der Formel (Ia) und/oder (IIa) 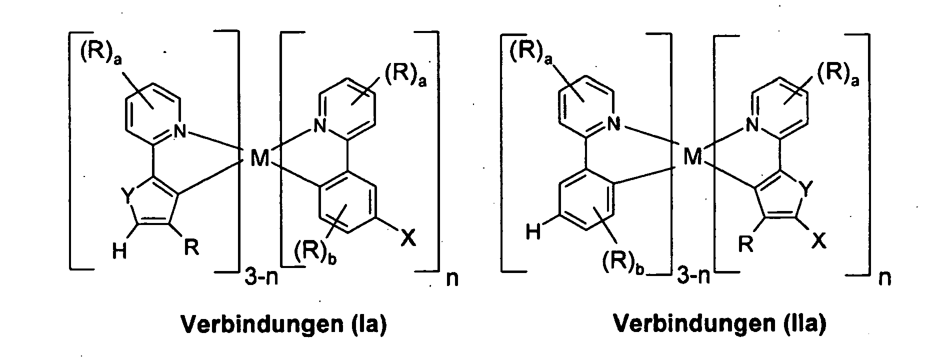 und/oder der Formel (IX), (XI), (XIII) und/oder (XV) 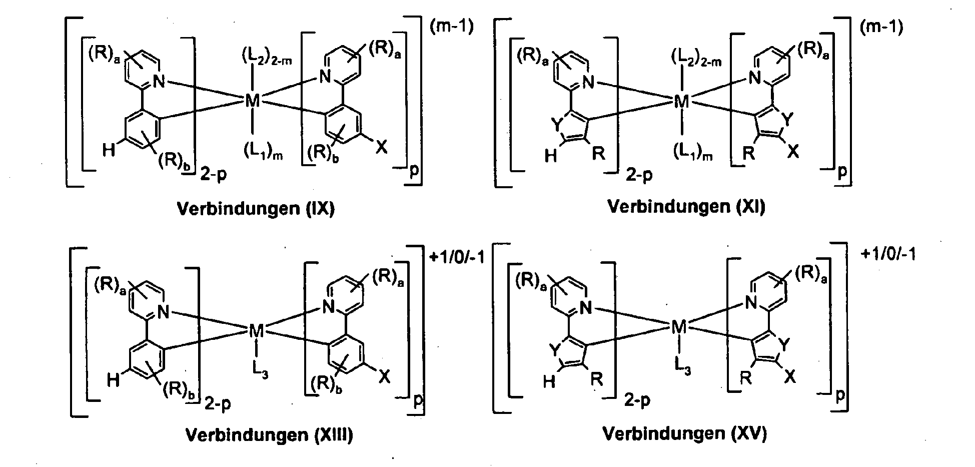 wobei die Symbole und Indizes folgende Bedeutung haben:
M ist gleich Rh, Ir
Y ist gleich oder verschieden O, S, Se
R ist gleich oder verschieden bei jedem Auftreten H, F, Cl, Br, NO₂, CN, eine geradkettige oder verzweigte oder cyclische Alkyl- oder Alkoxygruppe mit 1 bis 20 C-Atomen, wobei ein oder mehrere nicht benachbarte CH₂-Gruppen durch -O-, -S-, -NR¹-, oder -CONR² - ersetzt sein können und wobei ein oder mehrere H-Atome durch F ersetzt sein können, oder eine Aryl- oder Heteroarylgruppe mit 4 bis 14 C-Atomen, die durch einen oder mehrere, nicht aromatische Reste R substituiert sein kann; wobei mehrere Substituenten R, sowohl am selben Ring als auch an den beiden unterschiedlichen Ringen zusammen wiederum ein weiteres mono- oder polycyclisches Ringsystem aufspannen können;
R¹ und R² sind gleich oder verschieden, H oder ein aliphatischer oder aromatischer Kohlenwasserstoffrest mit 1 bis 20 C-Atomen,
L₁ ist ein neutraler, einzähniger Ligand
L₂ ist ein monoanionischer, einzähniger Ligand
L₃ ist ein neutaler oder mono- oder dianionischer zweizähniger Ligand
a ist gleich oder verschieden 0, 1, 2, 3 oder 4, bevorzugt 0, 1 oder 2,
b ist gleich oder verschieden 0, 1, 2 oder 3, bevorzugt 0 oder 1.
n ist 1, 2 oder 3 und
m ist 0, 1 oder 2
p ist 1 oder 2
X eine Bindung zum konjugierten oder teilkonjugierten Polymer darstellt.

20. Polymere gemäß Anspruch 19, **dadurch gekennzeichnet, daß** das Polymer aus der Gruppe Polyfluorene, Poly-spirobifluorene, Poly-para-phenylene, Poly-carbazole und Polythiophene ausgewählt ist.

21. Polymere gemäß Anspruch 19 und 20, **dadurch gekennzeichnet, daß** das Polymer ein Homo- oder Copolymer ist.

22. Polymere gemäß einem der Ansprüche 19 bis 21, **dadurch gekennzeichnet, daß** das Polymer in organischen Lösemitteln löslich ist.

23. Elektrisches Bauteil enthaltend mindestens ein Polymer gemäß einem der Ansprüche 19 bis 22.

## Claims

1. Compound of the formulae (I), (II), (Ia), (IIa), (V), (VII), (IX), (XI), (XIII) and (XV) 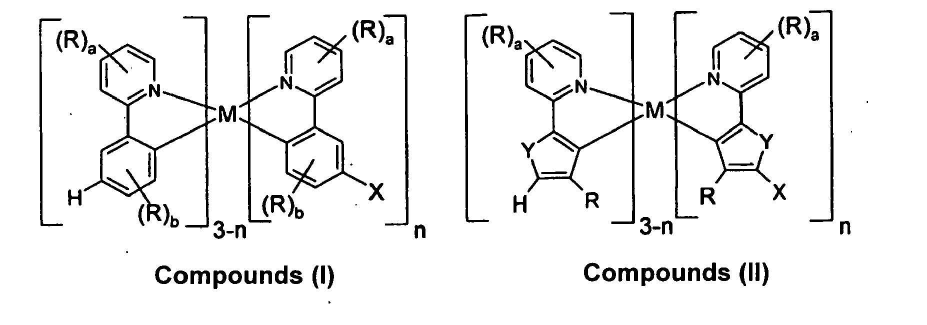 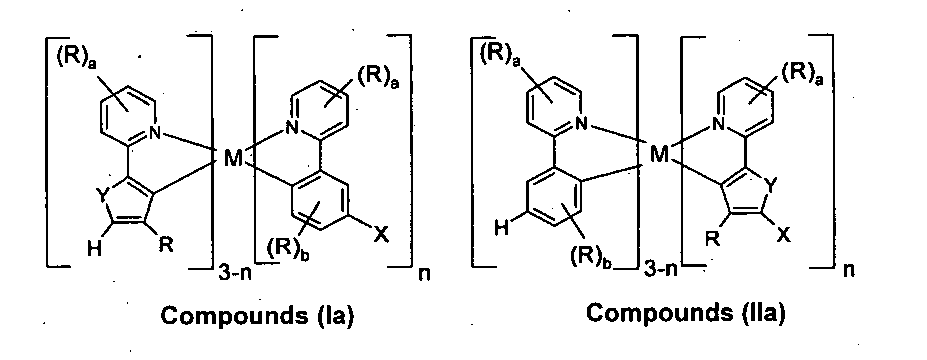 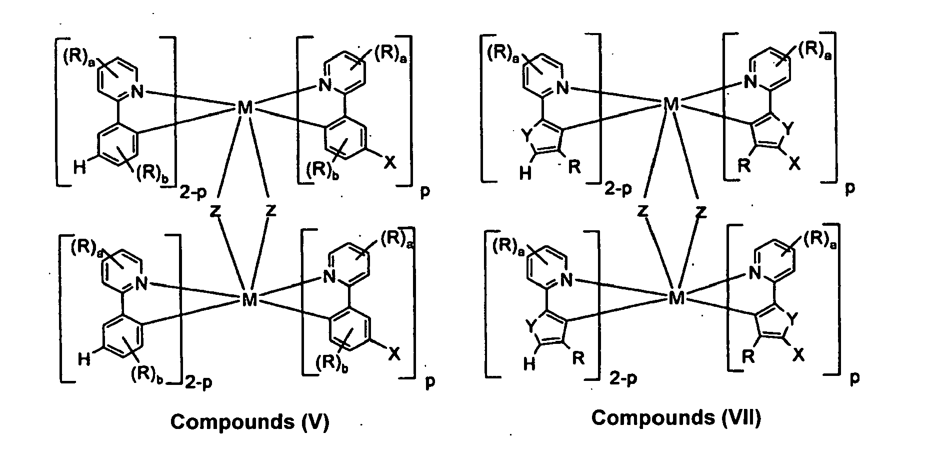 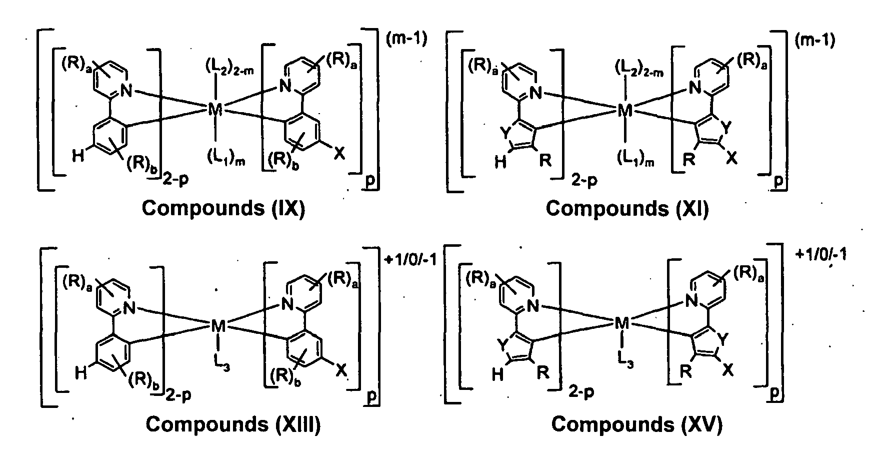 where the symbols and indices have the following meaning:
M is, identically, Rh, Ir;
X is, identically or differently, Cl, Br, I;
Y is, identically or differently, O, S, Se;
Z is, identically, F, Cl, Br, I, O-R¹, S-R¹, N(R¹)₂;
R is, identically or differently on each occurrence, H, F, Cl, Br, NO₂, CN, a straight-chain or branched or cyclic alkyl or alkoxy group having 1 to 20 C atoms, in which one or more non-adjacent CH₂ groups may be replaced by -O-, -S-, -NR¹- or -CONR²- and in which one or more H atoms may be replaced by F, or an aryl or heteroaryl group having 4 to 14 C atoms, which may be substituted by one or more non-aromatic radicals R; where a plurality of substituents R, both on the same ring and also on the two different rings, may together in turn form a further mono- or polycyclic ring system;
R¹ and R² are, identically or differently, H or an aliphatic or aromatic hydrocarbon radical having 1 to 20 C atoms;
L₁ is a neutral, monodentate ligand;
L₂ is a monoanionic, monodentate ligand;
L₃ is a neutral or mono- or dianionic bidentate ligand;
a is, identically or differently, 0, 1, 2, 3 or 4, preferably 0, 1 or 2;
b is, identically or differently, 0, 1, 2 or 3, preferably 0 or 1;
n is 1, 2 or 3;
m is 0, 1 or 2;
p is 1 or 2;
where the following compound is excluded from the invention:

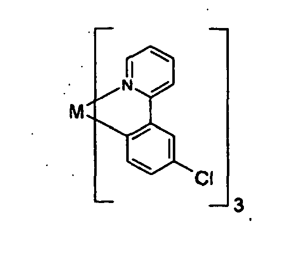

2. Compounds according to Claim 1, **characterised in that** L₁ is carbon monoxide, an isonitrile, such as, for example, *tert*-butyl isonitrile, cyclohexyl isonitrile, adamantyl isonitrile, an amine, such as, for example, trimethylamine, triethylamine, morpholine, a phosphine, such as, for example, trifluorophosphine, trimethylphosphine, tricyclohexylphosphine, tri-*tert*-butylphosphine, triphenylphosphine, tris(pentafluorophenyl)phosphine, a phosphite, such as, for example, trimethyl phosphite, triethyl phosphite, an arsine, such as, for example, trifluoroarsine, trimethylarsine, tricyclohexylarsine, tri-*tert*-butylarsine, triphenylarsine, tris(pentafluorophenyl)arsine, a stibine, such as, for example, trifluorostibine, trimethylstibine, tricyclohexylstibine, tri-*tert*-butylstibine, triphenylstibine, tris(pentafluorophenyl)stibine, or a nitrogen-containing heterocycle, such as pyridine, pyridazine, pyrazine, triazine.

3. Compounds according to Claim 1, **characterised in that** L₂ is a halide, cyanide, cyanate, isocyanate, thiocyanate, isothiocyanate, an alkoxide, such as, for example, methoxide, ethoxide, propoxide, isopropoxide, *tert-*butoxide, phenoxide, a thioalkoxide, such as, for example, methane thiolate, ethane thiolate, propane thiolate, isopropane thiolate, *tert*-thiobutoxide, thiophenoxide, an amide, such as, for example, dimethylamide, diethylamide, diisopropylamide, pyrrolide, morpholide, a carboxylate, such as, for example, acetate, trifluoroacetate, propionate, benzoate, or an anionic nitrogen-containing heterocycle, such as pyrrolide, imidazolide, pyrazolide.

4. Compounds according to Claim 1, **characterised in that** L₃ is a diamine, such as, for example, ethylenediamine, N,N,N',N'-tetramethylethylenediamine, propylenediamine, N,N,N',N'-tetramethylpropylenediamine, cis-, trans-diaminocyclohexane, cis-, trans-N,N,N',N'-tetramethyldiaminocyclohexane, an imine, such as, for example, 2-[1-(phenylimino)ethyl]pyridine, 2-[1-(2-methylphenylimino)ethyl]pyridine, 2-[1-(2,6-diisopropylphenylimino)-ethyl]pyridine, 2-[1-(methylimino)ethyl]pyridine, 2-[1-(ethylimino)ethyl]pyridine, 2-[1-(isopropylimino)ethyl]pyridine, 2-[1-(*tert*-butylimino)ethyl]pyridine, a diimine, such as, for example, 1,2-bis(methylimino)ethane, 1,2-bis(ethylimino)ethane, 1,2-bis(isopropylimino)ethane, 1,2-bis(*tert*-butylimino)ethane, 2,3-bis(methylimino)butane, 2,3-bis(ethylimino)butane, 2,3-bis(isopropylimino)butane, 2,3-bis(*tert*-butylimino)butane, 1,2-bis(phenylimino)ethane, 1,2-bis(2-methylphenylimino)ethane, 1,2-bis(2,6-diisopropylphenylimino)-ethane, 1,2-bis(2,6-di-*tert*-butylphenylimino)ethane, 2,3-bis(phenylimino)-butane, 2,3-bis(2-methylphenylimino)butane, 2,3-bis(2,6-diisopropylphenylimino)butane, 2,3-bis(2,6-di-*tert*-butylphenylimino)butane, a heterocycle containing two nitrogen atoms, such as, for example, 2,2'-bipyridine, o-phenanthroline, a diphosphine, such as, for example, bis(diphenylphosphino)methane, bis(diphenylphosphino)ethane, bis(diphenylphosphino)-propane, bis(dimethylphosphino)methane, bis(dimethylphosphino)ethane, bis(dimethylphosphino)propane, bis(diethylphosphino)methane, bis(diethylphosphino)ethane, bis(diethylphosphino)propane, bis(di-*tert*-butylphosphino)methane, bis(di-*tert*-butylphosphino)ethane, bis(*tert*-butylphosphino)-propane, a 1,3-diketonate derived from 1,3-diketone, such as, for example, acetylacetone, benzoylacetone, 1,5-diphenylacetylacetone, dibenzoylmethane, bis(1,1,1-trifluoroacetyl)methane, a 3-ketonate derived from 3-keto esters, such as, for example, ethyl acetoacetate, a carboxylate derived from aminocarboxylic acids, such as, for example, pyridine-2-carboxylic acid, quinoline-2-carboxylic acid, glycine, dimethylglycine, alanine, dimethylaminoalanine, a salicyliminate derived from salicylimines, such as, for example, methylsalicylimine, ethylsalicylimine, phenylsalicylimine, a dialkoxide derived from dialcohols, such as, for example, ethylene glycol, 1,3-propylene glycol, a dithiolate derived from dithiols, such as, for example, 1,2-ethylene dithiolate, 1,3-propylene dithiolate.

5. Process for the preparation of the compounds defined in Claim 1, by reaction of the compounds (III) or (IV) or (VI) or (VIII) or (X) or (XII) or (XIV) or (XVI) 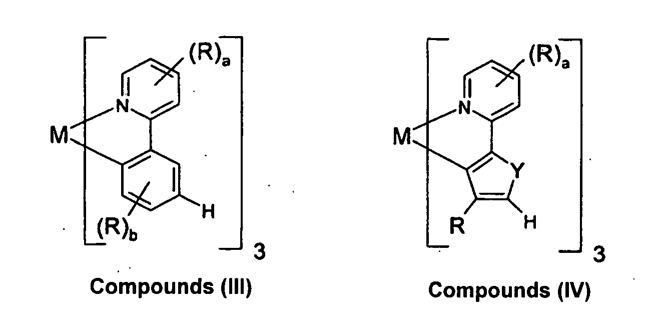 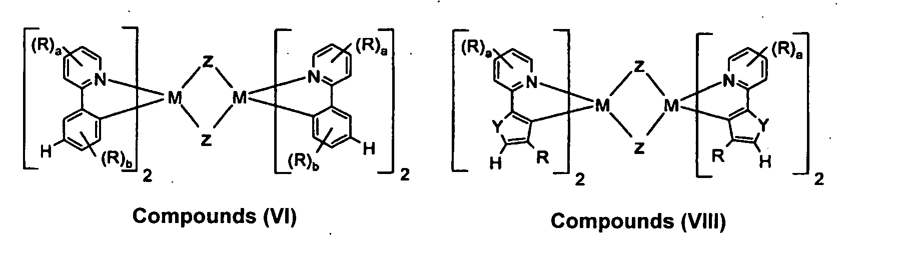 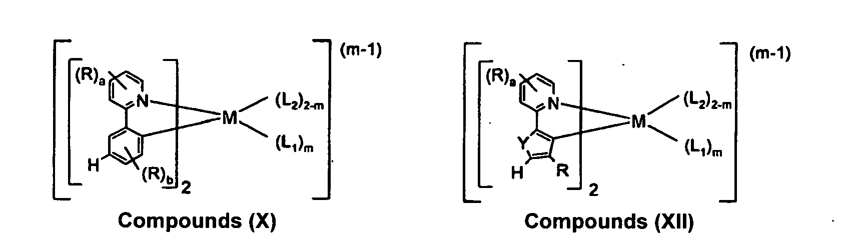 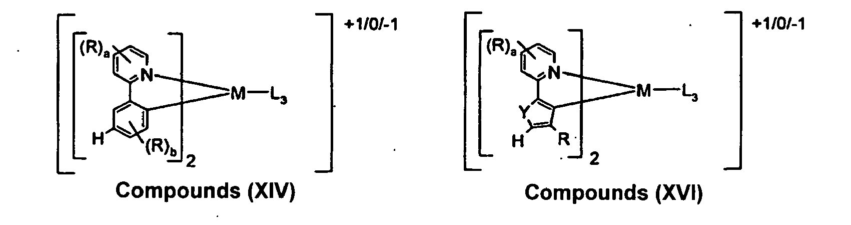 in which M and the radicals and indices Y, Z, R, L₁, L₂, L₃, a, b and m have the meanings mentioned in Claim 1, with halogenating agents.

6. Process according to Claim 5, **characterised in that** the halogenating agent used is a halogen X₂ or an interhalogen X-X and a base in the ratio 1 : 1 to 1 : 100 or an organic bromine complex, such as pyridinium perbromide, and in each case optionally a Lewis acid in the ratio (halogen to Lewis acid) 1 : 0.1 to 1 : 0.0001.

7. Process according to Claim 6, **characterised in that** the halogen or interhalogen used is chlorine, bromine or iodine, or chlorine fluoride, bromine fluoride, iodine fluoride, bromine chloride, iodine chloride or iodine bromide respectively.

8. Process according to Claim 6 or 7, **characterised in that** the base used is an organic amine, such as triethylamine, tri-n-butylamine, diisopropylethylamine, morpholine, N-methylmorpholine and pyridine, or a salt of a carboxylic acid, such as sodium acetate, sodium propionate, sodium benzoate, or an inorganic base, such as sodium phosphate or hydrogenphosphate or potassium phosphate or hydrogenphosphate, sodium hydrogencarbonate or potassium hydrogencarbonate, sodium carbonate or potassium carbonate.

9. Process according to one or more of Claims 6 to 8, **characterised in that** a Lewis acid, such as boron trifluoride, boron trifluoride etherate, boron trichloride, boron tribromide, boron triiodide, aluminium trichloride, aluminium tribromide, aluminium triiodide, iron(III) chloride, iron(III) bromide, zinc(II) chloride, zinc(II) bromide, tin(IV) chloride, tin(IV) bromide, phosphorus pentachloride, arsenic pentachloride and antimony pentachloride, is used.

10. Process according to Claim 5, **characterised in that** the halogenating agent used is an organic N-X compound.

11. Process according to Claim 10, **characterised in that** the organic N-X compound used is 1-(chloromethyl)-4-fluoro-1,4-diazoniabicyclo[2.2.2]-octane bis(tetrafluoroborate), N-halocarboxamides, such as N-chloro-, N-bromo- and N-iodoacetamide, N-chloro-, N-bromo- and N-iodopropionamide, N-chloro-, N-bromo- and N-iodobenzamide, or N-halocarboximides, such as N-chloro-, N-bromo- and N-iodosuccinimide, N-chloro-, N-bromo-and N-iodophthalimide, or N-dihalosulfonamides, such as benzenesulfo-N-dibromamide, or N-halosulfonamide salts, such as chloramine B or T.

12. Process according to Claim 5, **characterised in that** the halogenating agent used is an organic O-X compound and a halogen X₂ in a molar ratio of 0.5 : 1 to 1 : 1.

13. Process according to Claim 12, **characterised in that** the organic O-X compounds used are iodoaryl dicarboxylates, such as iodobenzene diacetate or bistrifluoroacetoxyiodobenzene.

14. Process according to Claim 5, **characterised in that** a stoichiometric ratio of the halogenating agents according to Claims 11, 15 or 17 - based on the content of active halogen - to the compounds (III), (IV), (X), (XII), (XIV) or (XVI) of 1 : 1 is used.

15. Process according to Claim 5, **characterised in that** a stoichiometric ratio of the halogenating agents according to Claims 11, 15 or 17 - based on the content of active halogen - to the compounds (III), (IV), (VI), (VIII), (X), (XII), (XIV) or (XVI) of 2 : 1 is used.

16. Process according to Claim 5, **characterised in that** a stoichiometric ratio of the halogenating agents according to Claims 11, 15 or 17 - based on the content of active halogen - to the compounds (III) or (IV) of 3 : 1 is used.

17. Process according to Claim 5, **characterised in that** a stoichiometric ratio of the halogenating agents according to Claims 11, 15 or 17 - based on the content of active halogen - to the compounds (VI) or (VIII) in the range from 4 : 1 to 1000 : 1 is used.

18. Compounds according to Claim 1, **characterised in that** their purity (determined by means of 1 H-NMR or HPLC) is greater than 99%.

19. Conjugated or partially conjugated polymers comprising one or more compounds of the formulae (I) and/or (II) 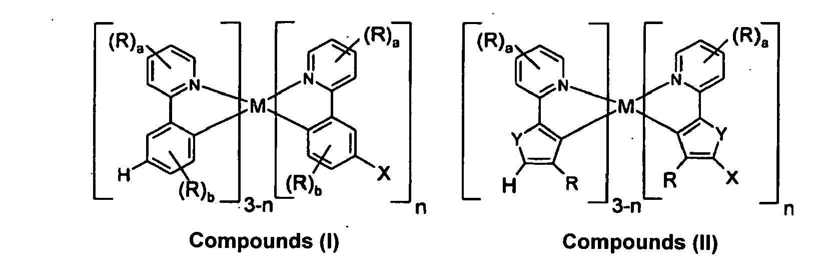 and/or of the formulae (Ia) and/or (IIa) 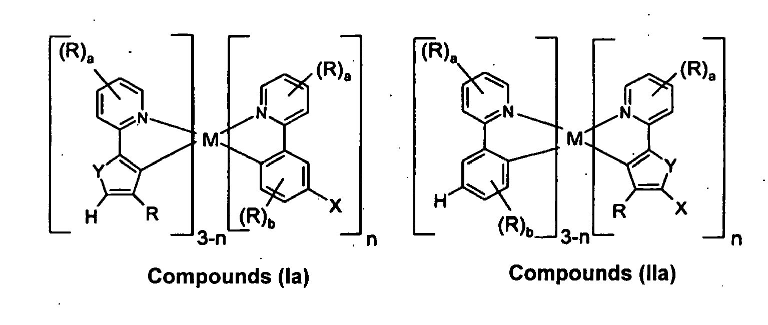 and/or of the formula (IX), (XI), (XIII) and/or (XV) 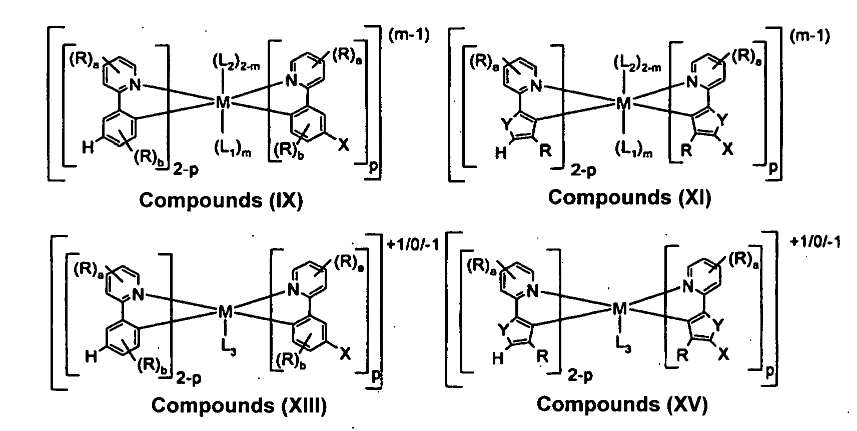 where the symbols and indices have the following meaning:
M is, identically, Rh, Ir;
Y is, identically or differently, O, S, Se;
R is, identically or differently on each occurrence, H, F, Cl, Br, NO₂, CN, a straight-chain or branched or cyclic alkyl or alkoxy group having 1 to 20 C atoms, in which one or more non-adjacent CH₂ groups may be replaced by -O-, -S-, -NR¹- or -CONR²- and in which one or more H atoms may be replaced by F, or an aryl or heteroaryl group having 4 to 14 C atoms, which may be substituted by one or more non-aromatic radicals R; where a plurality of substituents R, both on the same ring and also on the two different rings, may together in turn form a further mono- or polycyclic ring system;
R¹ and R² are, identically or differently, H or an aliphatic or aromatic hydrocarbon radical having 1 to 20 C atoms;
L₁ is a neutral, monodentate ligand;
L₂ is a monoanionic, monodentate ligand;
L₃ is a neutral or mono- or dianionic bidentate ligand;
a is, identically or differently, 0, 1, 2, 3 or 4, preferably 0, 1 or 2;
b is, identically or differently, 0, 1, 2 or 3, preferably 0 or 1;
n is 1, 2 or 3;
m is 0, 1 or 2;
p is 1 or 2;
X represents a bond to the conjugated or partially conjugated polymer.

20. Polymers according to Claim 19, **characterised in that** the polymer is selected from the group of polyfluorenes, polyspirobifluorenes, poly-paraphenylenes, polycarbazoles and polythiophenes.

21. Polymers according to Claims 19 and 20, **characterised in that** the polymer is a homo- or copolymer.

22. Polymers according to one of Claims 19 to 21, **characterised in that** the polymer is soluble in organic solvents.

23. Electrical component comprising at least one polymer according to one of Claims 19 to 22.

## Revendications

1. Composé de formules (I), (II), (la), (IIa), (V), (VII), (IX), (XI), (XIII) et (XV), 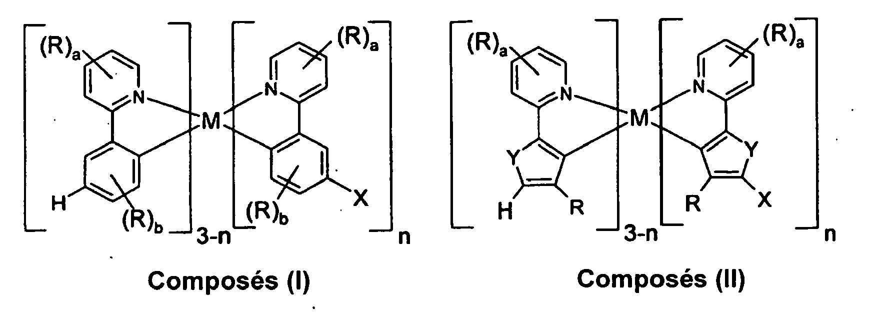 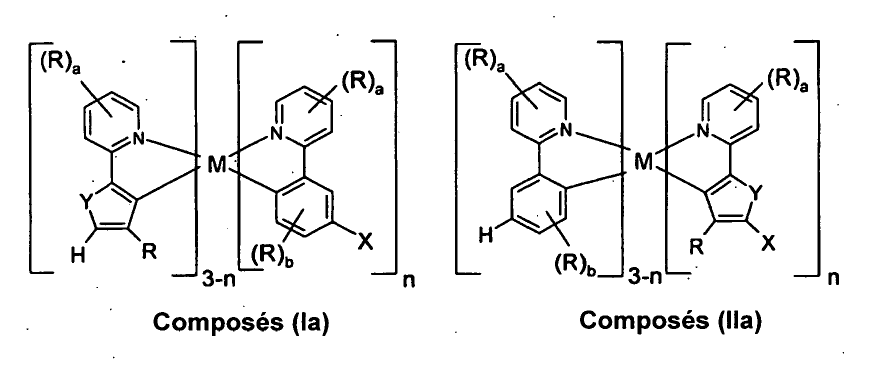 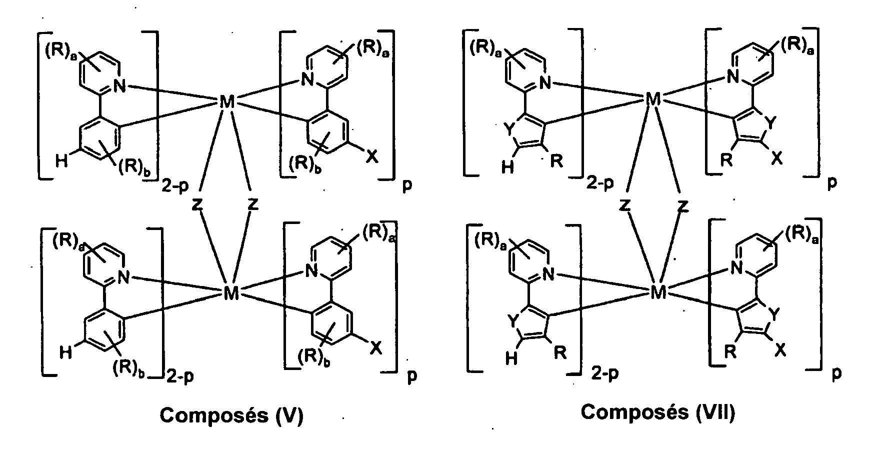 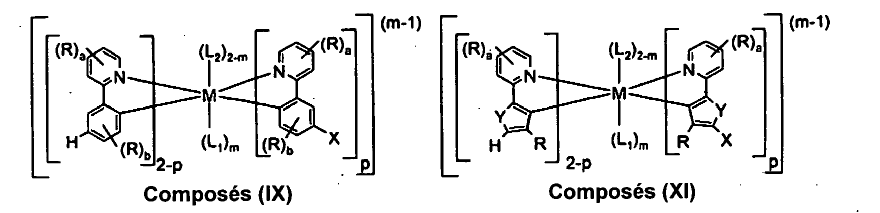 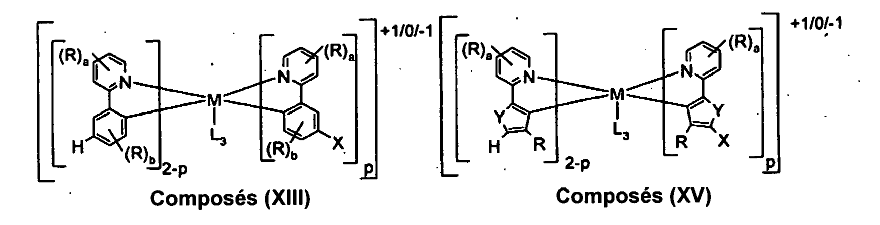 où les symboles et indices ont la signification suivante :
M est, de manière identique, Rh, Ir ;
X est, de manière identique ou différente, Cl, Br, I ;
Y est, de manière identique ou différente, O, S, Se ;
Z est, de manière identique, F, Cl, Br, I, O-R¹, S-R¹, N(R¹)₂ ;
R est, de manière identique ou différente à chaque occurrence, H, F, Cl, Br, NO₂, CN, un groupement alkyle ou alcoxy à chaîne linéaire ou ramifiée ou cyclique ayant de 1 à 20 atomes de C, dans lequel un ou plusieurs groupements CH₂ non adjacents peuvent être remplacés par -O-, -S-, -NR¹- ou -CONR²- et dans lequel un ou plusieurs atomes de H peuvent être remplacés par F, ou un groupement aryle ou hétéroaryle ayant de 4 à 14 atomes de C, pouvant être substitué par un ou plusieurs radicaux non aromatiques R ; où une pluralité de substituants R, tous deux sur le même cycle et également sur les deux cycles différents, peuvent ensemble à leur tour former un noyau mono- ou polycyclique supplémentaire ;
R¹ et R² sont, de manière identique ou différente, H ou un radical hydrocarboné aliphatique ou aromatique ayant de 1 à 20 atomes de C ;
L₁ est un ligand monodenté neutre ;
L₂ est un ligand monodenté mono-anionique ;
L₃ est un ligand bidenté neutre ou mono- ou di-anionique ;
a est, de manière identique ou différente, 0, 1, 2, 3 ou 4, préférablement 0, 1 ou 2 ;
b est, de manière identique ou différente, 0, 1, 2 ou 3, préférablement 0 ou 1 ;
n est 1, 2 ou 3 ;
m est 0, 1 ou 2 ;
p est 1 ou 2 ;
le composé suivant étant exclus de l'invention :

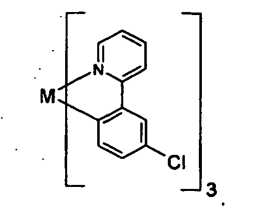

2. Composés selon la revendication 1, **caractérisés en ce que** L₁ est le monoxyde de carbone, un isonitrile, tel que, par exemple, le *tertio*-butyl isonitrile, le cyclohexyl isonitrile, l'adamantyl isonitrile, une amine, telle que, par exemple, la triméthylamine, la triéthylamine, la morpholine, une phosphine, telle que, par exemple, la trifluorophosphine, la triméthylphosphine, la tricyclohexylphosphine, la tri-*tertio*-butylphosphine, la triphénylphosphine, la tris(pentafluorophényl)phosphine, un phosphite, tel que, par exemple, le triméthyl phosphite, le triéthyl phosphite, une arsine, telle que, par exemple, la trifluoroarsine, la triméthylarsine, la tricyclohexylarsine, la tri-*tertio*-butylarsine, la triphénylarsine, la tris(pentafluorophényl)arsine, une stibine, telle que, par exemple, la trifluorostibine, la triméthylstibine, la tricyclohexylstibine, la tri-*tertio*-butylstibine, la triphénylstibine, la tris(pentafluorophényl)stibine, ou un hétérocycle azoté, tel que la pyridine, la pyridazine, la pyrazine, la triazine.

3. Composés selon la revendication 1, **caractérisés en ce que** L₂ est un halogénure, un cyanure, un cyanate, un isocyanate, un thiocyanate, un isothiocyanate, un alkylate, tel que, par exemple, le méthylate, l'éthylate, le propylate, l'isopropylate, le *tertio*-butylate, le phénylate, un thioalkylate, tel que, par exemple, le méthane thiolate, l'éthane thiolate, le propane thiolate, l'isopropane thiolate, le *tertio*-thiobutylate, le thiophénylate, un amide, tel que, par exemple, le diméthylamide, le diéthylamide, le diisopropylamide, le pyrrolide, le morpholide, un carboxylate, tel que, par exemple, l'acétate, le trifluoracétate, le propionate, le benzoate, ou un hétérocycle azoté anionique, tel que le pyrrolide, l'imidazolide, le pyrazolide.

4. Composés selon la revendication 1, **caractérisés en ce que** L₃ est une diamine, telle que, par exemple, l'éthylènediamine, la N,N,N',N'-tétraméthyléthylènediamine, la propylènediamine, la N,N,N',N'-tétraméthylpropylènediamine, le cis-, trans-diaminocyclohexane, le cis-, trans-N,N,N',N'-tétraméthyldiaminocyclohexane, une imine, telle que, par exemple, la 2-[1-(phénylimino)éthyl]pyridine, la 2-[1-(2-méthylphénylimino)éthyl]-pyridine, la 2-[1-(2,6-diisopropylphénylimino)éthyl]pyridine, la 2-[1-(méthylimino)éthyl]pyridine, la 2-[1-(éthylimino)éthyl]pyridine, la 2-[1-(isopropylimino)éthyl]pyridine, la 2-[1-(*tertio*-butylimino)éthyl]pyridine, une diimine, telle que, par exemple, le 1,2-bis(méthylimino)éthane, le 1,2-bis(éthylimino)éthane, le 1,2-bis(isopropylimino)éthane, le 1,2-bis(*tertio*-butylimino)-éthane, le 2,3-bis(méthylimino)butane, le 2,3-bis(éthylimino)butane, le 2,3-bis(isopropylimino)butane, le 2,3-bis(*tertio*-butylimino)butane, le 1,2-bis-(phénylimino)éthane, le 1,2-bis(2-méthylphénylimino)éthane, le 1,2-bis(2,6-diisopropylphénylimino)éthane, le 1,2-bis(2,6-di-*tertio*-butylphénylimino)-éthane, le 2,3-bis(phénylimino)butane, le 2,3-bis(2-méthylphénylimino)-butane, le 2,3-bis(2,6-diisopropylphénylimino)butane, le 2,3-bis(2,6-ditertio-butylphénylimino)butane, un hétérocycle contenant deux atomes d'azote, tel que, par exemple, la 2,2'-bipyridine, la o-phénanthroline, une diphosphine, telle que, par exemple, le bis(diphénylphosphino)méthane, le bis(diphénylphosphino)éthane, le bis(diphénylphosphino)propane, le bis-(diméthylphosphino)méthane, le bis(diméthylphosphino)éthane, le bis-(diméthylphosphino)propane, le bis(diéthylphosphino)méthane, le bis-(diéthylphosphino)éthane, le bis(diéthylphosphino)propane, le bis(di-*tertio-*butylphosphino)méthane, le bis(di-*tertio*-butylphosphino)éthane, le bis-(*tertio*-butylphosphino)propane, un 1,3-dicétonate dérivé de 1,3-dicétone, tel que, par exemple, l'acétylacétone, la benzoylacétone, la 1,5-diphénylacétylacétone, le dibenzoylméthane, le bis(1,1,1-trifluoroacétyl)méthane, un 3-cétonate dérivé de 3-céto esters, tel que, par exemple, l'acétoacétate d'éthyle, un carboxylate dérivé d'acides aminocarboxyliques, tel que, par exemple, l'acide pyridine-2-carboxylique, l'acide quinoléine-2-carboxylique, la glycine, la diméthylglycine, l'alanine, la diméthylaminoalanine, un salicyliminate dérivé de salicylimines, tel que, par exemple, la méthylsalicylimine, l'éthylsalicylimine, la phénylsalicylimine, un dialkylate dérivé de dialcools, tel que, par exemple, l'éthylène glycol, le 1,3-propylène glycol, un dithiolate dérivé de dithiols, tel que, par exemple, le 1,2-éthylène dithiolate, le 1,3-propylène dithiolate.

5. Procédé de préparation des composés définis selon la revendication 1, par réaction des composés (III) ou (IV) ou (VI) ou (VIII) ou (X) ou (XII) ou (XIV) ou (XVI), 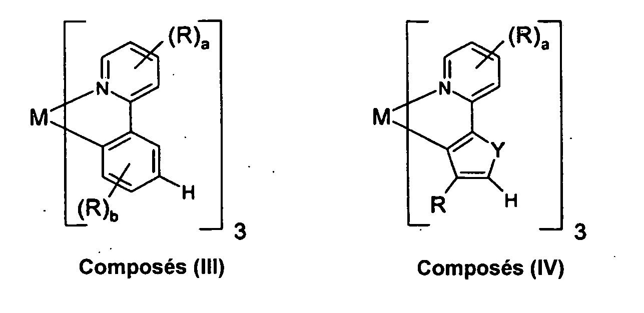 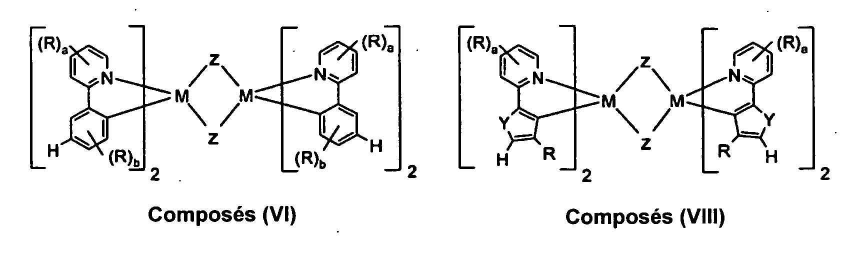 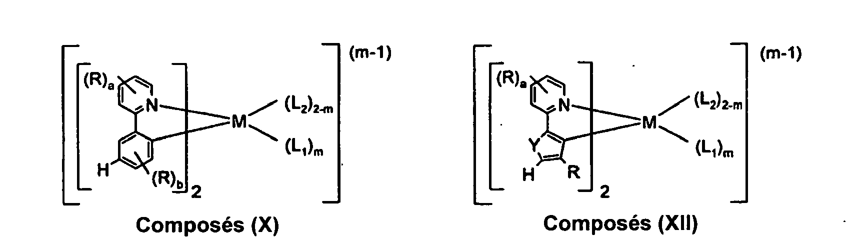 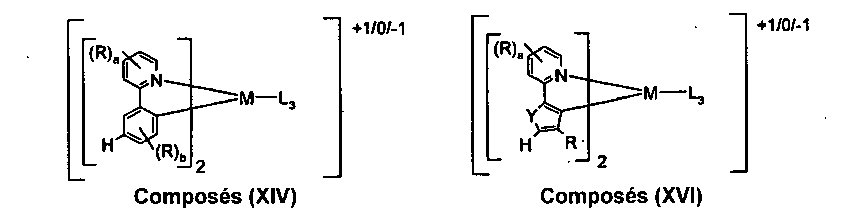 dans lesquels M et les radicaux et indices Y, Z, R, L₁, L₂, L₃, a, b et m ont les significations selon la revendication 1, avec des agents d'halogénation.

6. Procédé selon la revendication 5, **caractérisé en ce que** l'agent d'halogénation utilisé est un halogène X₂ ou un interhalogène X-X et une base selon le rapport 1:1 à 1:100 ou un complexe de brome organique, tel que le perbromure de pyridinium, et dans chaque cas éventuellement un acide de Lewis selon le rapport (halogène à acide de Lewis) 1:0,1 à 1:0,0001.

7. Procédé selon la revendication 6, **caractérisé en ce que** l'halogène ou l'interhalogène utilisé est le chlore, le brome ou l'iode, ou le fluorure de chlore, le fluorure de brome, le fluorure d'iode, le chlorure de brome, le chlorure d'iode ou le bromure d'iode, respectivement.

8. Procédé selon la revendication 6 ou 7, **caractérisé en ce que** la base utilisée est une amine organique, telle que la triéthylamine, la tri-n-butylamine, la diisopropyléthylamine, la morpholine, la N-méthylmorpholine et la pyridine, ou un sel d'un acide carboxylique, tel que l'acétate de sodium, le propionate de sodium, le benzoate de sodium, ou une base inorganique, telle que le phosphate ou l'hydrogénophosphate de sodium ou le phosphate ou l'hydrogénophosphate de potassium, l'hydrogénocarbonate de sodium ou l'hydrogénocarbonate de potassium, le carbonate de sodium ou le carbonate de potassium.

9. Procédé selon l'une ou plusieurs des revendications 6 à 8, **caractérisé en ce qu'**un acide de Lewis, tel que le trifluorure de bore, l'éthérate du trifluorure de bore, le trichlorure de bore, le tribromure de bore, le triiodure de bore, le trichlorure d'aluminium, le tribromure d'aluminium, le triiodure d'aluminium, le chlorure de fer(III), le bromure de fer(III), le chlorure de zinc(II), le bromure de zinc(II), le chlorure d'étain(IV), le bromure d'étain(IV), le pentachlorure de phosphore, le pentachlorure d'arsenic et le pentachlorure d'antimoine, est utilisé.

10. Procédé selon la revendication 5, **caractérisé en ce que** l'agent d'halogénation utilisé est un composé de N-X organique.

11. Procédé selon la revendication 10, **caractérisé en ce que** le composé de N-X organique utilisé est le bis(tétrafluoroborate) de 1-(chlorométhyl)-4-fluoro-1,4-diazoniabicyclo[2.2.2]octane, les N-halogénocarboxamides, tels que le N-chloro-, N-bromo- et N-iodoacétamide, le N-chloro-, N-bromo- et N-iodopropionamide, le N-chloro-, N-bromo- et N-iodobenzamide, ou les N-halogénocarboximides, tels que le N-chloro-, N-bromo- et N-iodosuccinimide, le N-chloro-, N-bromo- et N-iodophtalimide, ou les N-dihalogénosulfonamides, tels que le benzènesulfo-N-dibromamide, ou les sels de N-halogénosulfonamide, tels que la chloramine B ou T.

12. Procédé selon la revendication 5, **caractérisé en ce que** l'agent d'halogénation utilisé est un composé de O-X organique et un halogène X₂ selon un rapport molaire de 0,5:1 à 1:1.

13. Procédé selon la revendication 12, **caractérisé en ce que** les composés de O-X organiques utilisés sont des dicarboxylates d'iodoaryle, tels que le diacétate d'iodobenzène ou le bistrifluoroacétoxyiodobenzène.

14. Procédé selon la revendication 5, **caractérisé en ce qu'**un rapport stoechiométrique des agents d'halogénation selon les revendications 11, 15
ou 17 - sur la base de la teneur en halogène actif - aux composés (III), (IV), (X), (XII), (XIV) ou (XVI) de 1:1 est utilisé.

15. Procédé selon la revendication 5, **caractérisé en ce qu'u**n rapport stoechiométrique des agents d'halogénation selon les revendications 11, 15
ou 17 - sur la base de la teneur en halogène actif - aux composés (III), (IV), (VI), (VIII), (X), (XII), (XIV) ou (XVI) de 2:1 est utilisé.

16. Procédé selon la revendication 5, **caractérisé en ce qu'**un rapport stoechiométrique des agents d'halogénation selon les revendications 11, 15
ou 17 - sur la base de la teneur en halogène actif - aux composés (III) ou (IV) de 3:1 est utilisé.

17. Procédé selon la revendication 5, **caractérisé en ce qu'**un rapport stoechiométrique des agents d'halogénation selon les revendications 11, 15
ou 17 - sur la base de la teneur en halogène actif - aux composés (VI) ou (VIII) dans la plage de 4:1 à 1000:1 est utilisé.

18. Composés selon la revendication 1, **caractérisés en ce que** leur pureté (déterminée par RMN 1 H ou HPLC) est supérieure à 99%.

19. Polymères conjugués ou partiellement conjugués comprenant un ou plusieurs composés de formules (I) et/ou (II) 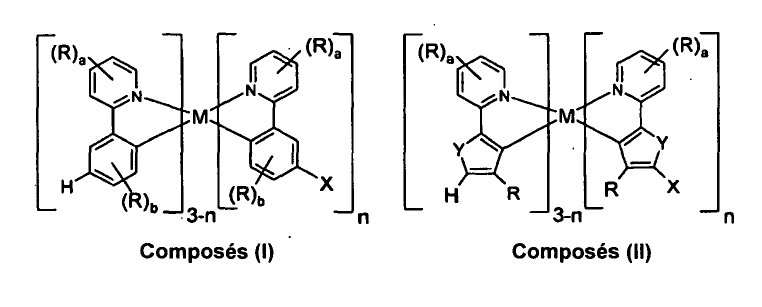 et/ou de formules (la) et/ou (IIa) 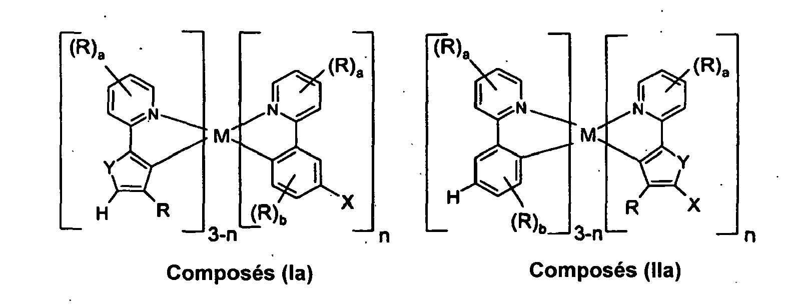 et/ou de formule (IX), (XI), (XIII) et/ou (XV) 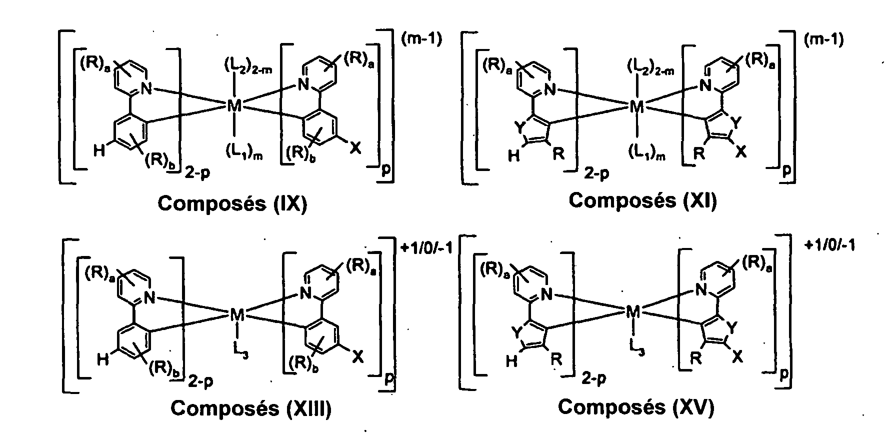 où les symboles et indices ont la signification suivante :
M est, de manière identique, Rh, Ir ;
Y est, de manière identique ou différente, O, S, Se ;
R est, de manière identique ou différente à chaque occurrence, H, F, CI, Br, NO₂, CN, un groupement alkyle ou alcoxy à chaîne linéaire ou ramifiée ou cyclique ayant de 1 à 20 atomes de C, dans lequel un ou plusieurs groupements CH₂ non adjacents peuvent être remplacés par -O-, -S-, -NR¹- ou -CONR²- et dans lequel un ou plusieurs atomes de H peuvent être remplacés par F, ou un groupement aryle ou hétéroaryle ayant de 4 à 14 atomes de C, pouvant être substitué par un ou plusieurs radicaux non aromatiques R ; où une pluralité de substituants R, tous deux sur le même cycle et également sur les deux cycles différents, peuvent ensemble à leur tour former un noyau mono- ou polycyclique supplémentaire ;
R¹ et R² sont, de manière identique ou différente, H ou un radical hydrocarboné aliphatique ou aromatique ayant de 1 à 20 atomes de C ;
L₁ est un ligand monodenté neutre ;
L₂ est un ligand monodenté mono-anionique ;
L₃ est un ligand bidenté neutre ou mono- ou di-anionique ;
a est, de manière identique ou différente, 0, 1, 2, 3 ou 4, préférablement 0, 1 ou 2 ;
b est, de manière identique ou différente, 0, 1, 2 ou 3, préférablement 0 ou 1 ;
n est 1, 2 ou 3;
m est 0, 1 ou 2 ;
p est 1 ou 2 ;
X représente une liaison au polymère conjugué ou partiellement conjugué.

20. Polymères selon la revendication 19, **caractérisés en ce que** le polymère est choisi parmi le groupe constitué par les polyfluorènes, les polyspirobifluorènes, les poly-para-phénylènes, les polycarbazoles et les polythiophènes.

21. Polymères selon les revendications 19 et 20, **caractérisés en ce que** le polymère est un homo- ou copolymère.

22. Polymères selon l'une des revendications 19 à 21, **caractérisés en ce que** le polymère est soluble dans les solvants organiques.

23. Composant électrique comprenant au moins un polymère selon l'une des revendications 19 à 22.
